# EUROPEAN PATENT APPLICATION

(11) **EP 4 709 114 A1**
(43) Date of publication of application: **11.03.2026**
(21) Application number: 25194312.2
(22) Date of filing: 06.08.2025
(51) Int. Cl.: H10K 59/122, H10K 59/131, H10K 59/80, H10K 59/88

(54) **DISPLAY DEVICE INCLUDING A DUMMY ELECTRODE, OPTICAL DEVICE AND ELECTRONICAL DEVICE**

(30) Priority: 06.09.2024 KR 20240121758
(71) Applicant: Samsung Display Co., Ltd., Yongin-si, Gyeonggi-do 17113 (KR)
(72) Inventor: Park, Sung Hyun, Yongin-si, Gyeonggi-do (KR); Seo, Joo Hong, Yongin-si, Gyeonggi-do (KR); Yang, Seung Suk, Yongin-si, Gyeonggi-do (KR)
(74) Representative: Gulde & Partner

(57) **Abstract**

A display device includes a substrate, first electrodes disposed on the substrate, a pixel defining layer disposed on the first electrodes and having a trench, a light emitting stack disposed on the first electrode and the pixel defining layer, and a dummy electrode disposed between the substrate and the trench, and between the first electrodes, wherein a voltage applied to the dummy electrode and a voltage applied to the first electrodes are different.

## Description

### BACKGROUND

### 1. Technical Field

The present disclosure relates to a display device including a dummy electrode, specifically a display device including a dummy electrode between neighboring pixels, an optical device and electronical device.

### 2. Discussion of Related Art

A head mounted display (HMD) is an image display device that may provide a visual display directly in front of a user's eyes. The head mounted display may be implemented as, for example, glasses, goggles, or a helmet. The head mounted display may display virtual reality (VR) or augmented reality (AR) type images.

The head mounted display may magnify an image displayed on a small display device by using a plurality of lenses, and display the magnified image. The display device applied to the head mounted display may provide high-resolution images, for example, images with a resolution of 3000 PPI (Pixels Per Inch) or higher. To this end, an organic light emitting diode on silicon (OLEDoS), which is a high-resolution small organic light emitting display device, may be used as the display device applied to the head mounted display. The OLEDoS is an image display device in which an organic light emitting diode (OLED) may be disposed on a semiconductor wafer substrate on which a complementary metal oxide semiconductor (CMOS) is disposed.

### SUMMARY

Aspects of the present disclosure provide a display device and an optical device capable of improving image quality by reducing leakage current between neighboring pixels.

According to an aspect of the present disclosure, there is provided a display device comprising: a substrate, a plurality of first electrodes disposed on the substrate; a pixel defining layer disposed on the first electrode and having a trench; a light emitting stack disposed on the plurality of first electrodes and the pixel defining layer; and a dummy electrode disposed between the substrate and the trench, and between the plurality of first electrodes, wherein a voltage applied to the dummy electrode and a voltage applied to the plurality of first electrodes are different.

According to an embodiment, the dummy electrode is connected to one of a ground, a first driving voltage line supplying a first driving voltage, or a third driving voltage line supplying an initialization voltage, and the voltage applied to the dummy electrode is smaller than the voltage applied to the plurality of first electrodes.

According to an embodiment, the dummy electrode overlaps the trench.

According to an embodiment, the trench defines a cavity, and a residual layer is disposed on a bottom surface of the trench below the cavity.

According to an embodiment, further comprising an insulating layer disposed between the dummy electrode and the trench.

According to an embodiment, a bottom surface of the trench is disposed above, and spaced apart from, a top surface of the dummy electrode.

According to an embodiment, the dummy electrode and the trench are connected to each other, and a top surface of the dummy electrode defines a bottom surface of the trench.

According to an embodiment, the dummy electrode is disposed along the trench in a plan view.

According to an embodiment, the pixel defining layer has a plurality of trenches surrounding different emission areas, and the dummy electrode overlaps a plurality of neighboring trenches.

According to an embodiment, wherein an edge of the dummy electrode overlaps the plurality of neighboring trenches.

According to an embodiment, wherein a central portion of the dummy electrode overlaps the pixel defining layer between the plurality of neighboring trenches.

According to an embodiment, wherein the dummy electrode does not overlap the trench, and the dummy electrode overlaps the pixel defining layer.

According to an embodiment, the pixel defining layer has a plurality of trenches surrounding different emission areas, and the dummy electrode overlaps a pixel defining layer between a plurality of neighboring trenches.

According to an embodiment, in plan view, the dummy electrode surrounds an emission area and defines the pixel defining layer.

According to an embodiment, in plan view, the dummy electrode has a through hole surrounding the emission area.

According to an embodiment, wherein, between the substrate and the trench, the dummy electrode includes a plurality of dummy electrodes disposed along a direction toward the trench from the substrate.

According to an embodiment, further comprising a reflective electrode connected to the first electrode, wherein the dummy electrode is disposed on a same layer as the reflective electrode, and the dummy electrode is formed of a same material as the reflective electrode.

According to an aspect of the present disclosure, there is provided an optical device comprising: a display device; and an optical path changing member on the display device, wherein the display device comprises: a substrate; a plurality of first electrodes disposed on the substrate; a pixel defining layer disposed on the plurality of first electrodes and having a trench; a light emitting stack disposed on the plurality of first electrodes and the pixel defining layer; and a dummy electrode disposed between the substrate and the trench, and between the plurality of first electrodes, wherein the dummy electrode defines a leakage current path from the plurality of first electrodes.

According to an embodiment, the dummy electrode is connected to one of a ground, a first driving voltage line supplying a first driving voltage, or a third driving voltage line supplying an initialization voltage, and a voltage applied to the dummy electrode is smaller than a voltage applied to the plurality of first electrodes

According to an aspect of the present disclosure, there is provided an electronical device comprising: a display device including a display panel, wherein the display device comprises: a substrate; a plurality of first electrodes disposed on the substrate; a pixel defining layer disposed on the plurality of first electrodes and having a trench; a light emitting stack disposed on the plurality of first electrodes and the pixel defining layer; and a dummy electrode disposed between the substrate and the trench, and between the plurality of first electrodes, wherein a voltage applied to the dummy electrode and a voltage applied to the plurality of first electrodes are different.

In accordance with a display device of an embodiment, leakage current between neighboring pixels may be reduced to improve image quality. For example, according to an embodiment, through a dummy electrode disposed adjacently to a trench, a path of the leakage current between neighboring pixels may be changed, and the leakage current between the neighboring pixels may be reduced.

### BRIEF DESCRIPTION OF THE DRAWINGS

Aspects and features of the present disclosure will become more apparent by describing in detail embodiments thereof with reference to the attached drawings, in which:
FIG. 1 is an exploded perspective view illustrating a display device according to an embodiment;
FIG. 2 is a block diagram illustrating a display device according to an embodiment;
FIG. 3 is an equivalent circuit diagram of a first sub-pixel according to an embodiment;
FIG. 4 is a layout diagram illustrating an example of a display panel according to an embodiment;
FIG. 5 is a layout diagram illustrating an example of the display area of FIG. 4;
FIG. 6 is a layout diagram illustrating another example of the display area of FIG. 4;
FIG. 7 is a cross-sectional view illustrating an example of a display panel taken along line I1-I1' of FIG. 5;
FIG. 8 is a cross-sectional view illustrating an example of area A1 of FIG. 7 in detail;
FIG. 9 is a cross-sectional view illustrating an example of area A2 of FIG. 7 in detail;
FIG. 10 is a cross-sectional view of a display device according to another embodiment;
FIG. 11 is a cross-sectional view of a display device according to still another embodiment;
FIG. 12 is a diagram for explaining a planar shape of a dummy electrode of FIG. 11;
FIG. 13 is a cross-sectional view of a display device according to still another embodiment;
FIG. 14 is a cross-sectional view of a display device according to still another embodiment;
FIG. 15 is a diagram for explaining a planar shape of a dummy electrode of FIG. 14;
FIG. 16 is a perspective view illustrating a head mounted display device according to an embodiment;
FIG. 17 is an exploded perspective view illustrating an example of the head mounted display device of FIG. 16; and
FIG. 18 is a perspective view illustrating a head mounted display device according to an embodiment.
FIG. 19 is a block diagram of an electronic device according to an embodiment.
FIGS. 20, 21, and 22 are schematic diagrams of electronic devices according to various embodiments.

### DETAILED DESCRIPTION

The present invention will now be described more fully hereinafter with reference to the accompanying drawings, in which preferred embodiments of the invention are shown. Aspects of the present disclosure may, however, be embodied in different forms and should not be construed as limited to embodiments set forth herein. Rather, embodiments are provided so that this disclosure will be thorough and complete, and will fully convey the scope of the invention to those skilled in the art.

It will also be understood that when a layer is referred to as being "on" another layer or substrate, the layer can be directly on the other layer or substrate, or intervening layers may also be present. In contrast, when an element is referred to as being "directly on" another element, there may be no intervening elements present. The same reference numbers indicate the same components throughout the specification. In the attached figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of one or more embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the present disclosure may be combined partially or totally. As will be clearly appreciated by those skilled in the art, technically various interactions and operations are possible. Various embodiments can be practiced individually or in combination.

Hereinafter, embodiments will be described in detail with reference to the accompanying drawings.

In conventional display devices, a leakage current between pixels may reduce an image quality by introducing a color mixing phenomenon between the neighboring pixels. According to aspects of the present disclosure, a leakage current between pixels may be reduced to eliminated. For example, according to an embodiment, a dummy electrode may be disposed between substrate and a trench (e.g. adjacently disposed to a trench) and between first electrodes (e.g. neighboring sub-pixels), and a leakage current (e.g., side leakage current) between the first electrodes (neighboring sub-pixels) may be reduced, wherein charges (e.g., charges of leakage current) from the first electrodes (e.g. sub-pixels) may flow to the dummy electrode. According to an embodiment, an electric field may be generated around the dummy electrode, and charges of a leakage current from light emitting stacks formed proximate to the trench may flow to the dummy electrode through a pixel defining layer and an insulating layer. Due to the electric field of the dummy electrode, charges of a leakage current may be collected in the dummy electrode, and the leakage current between the neighboring sub-pixels may be reduced.

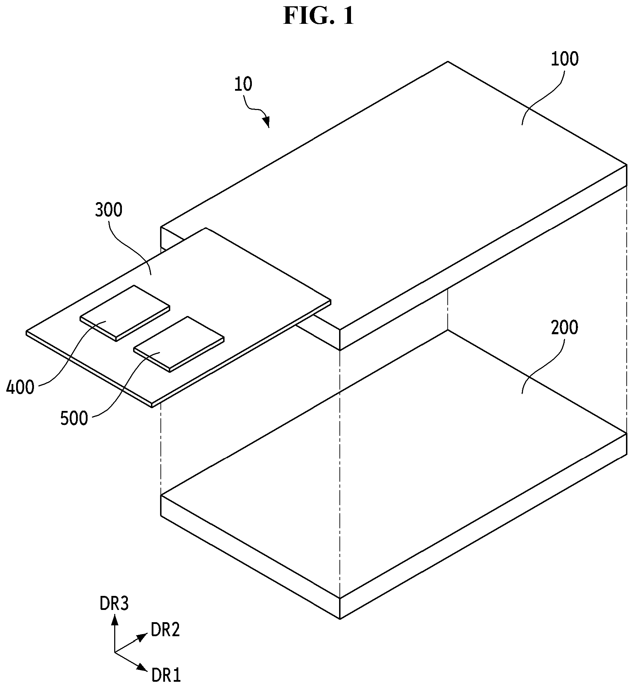

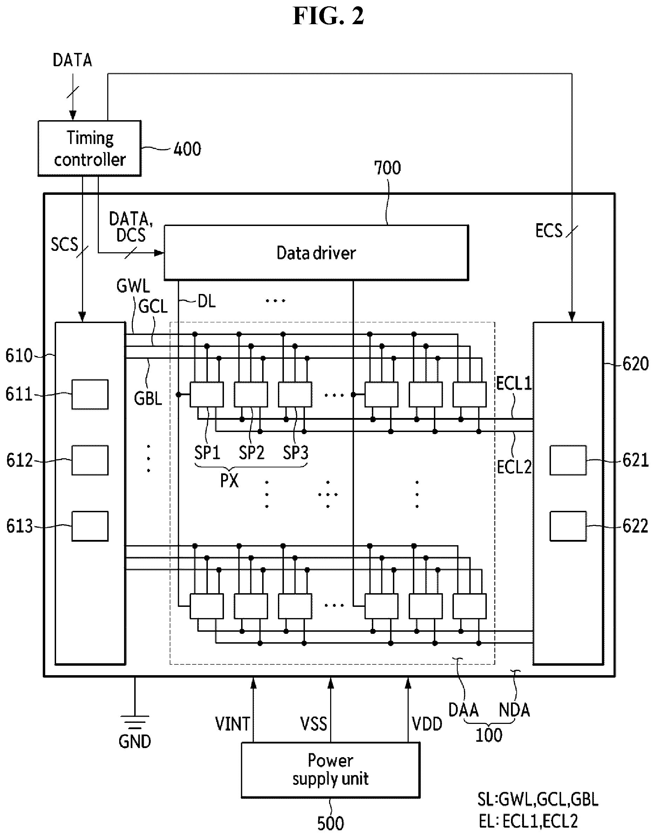

FIG. 1 is an exploded perspective view illustrating a display device according to an embodiment. FIG. 2 is a block diagram illustrating a display device according to an embodiment.

Referring to FIG. 1 and FIG. 2, a display device 10 according to an embodiment may be a device for displaying a moving image or a still image. The display device 10 according to an embodiment may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC) or the like. For example, the display device 10 according to an embodiment may be applied as a display unit of a television, a laptop, a monitor, a billboard, or an Internet-of-Things (IoT) terminal. Alternatively, the display device 10 according to an embodiment may be applied to a smart watch, a watch phone, a head mounted display (HMD) for implementing virtual reality and augmented reality, and the like.

The display device 10 according to an embodiment includes a display panel 100, a heat dissipation layer 200, a circuit board 300, a timing control circuit 400, and a power supply circuit 500.

The display panel 100 may have a planar shape. For example, the display panel 100 may have a quadrilateral shape, having a short side of a first direction DR1 and a long side of a second direction DR2 intersecting the first direction DR1. In the display panel 100, a corner where a short side in the first direction DR1 and a long side in the second direction DR2 meet may be right-angled or rounded with a predetermined curvature. The planar shape of the display panel 100 is not limited to a quadrilateral shape, and may be a shape similar to another polygonal shape, a circular shape, or an elliptical shape. The planar shape of the display device 10 may conform to the planar shape of the display panel 100, but the present disclosure is not limited thereto.

The display panel 100 may include a plurality of pixels PX, a plurality of scan lines SL, a plurality of emission control lines EL, a plurality of data lines DL, a scan driver 610, an emission driver 620, and a data driver 700. The display panel 100 may be divided into a display area DAA displaying an image and a non-display area NDA not displaying an image as shown in FIG. 2.

The plurality of pixels PX may be disposed in the display area DAA. The plurality of pixels PX may be arranged in a matrix form in the first direction DR1 and the second direction DR2. The plurality of scan lines SL and the plurality of emission control lines EL may extend in the first direction DR1, while being arranged in the second direction DR2. The plurality of data lines DL may extend in the second direction DR2, while being arranged in the first direction DR1.

The plurality of scan lines SL include a plurality of write scan lines GWL, a plurality of control scan lines GCL, and a plurality of bias scan lines GBL. The plurality of emission control lines EL include a plurality of first emission control lines ECL1 and a plurality of second emission control lines ECL2.

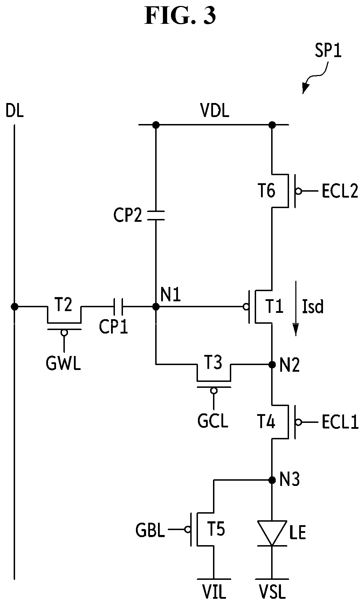

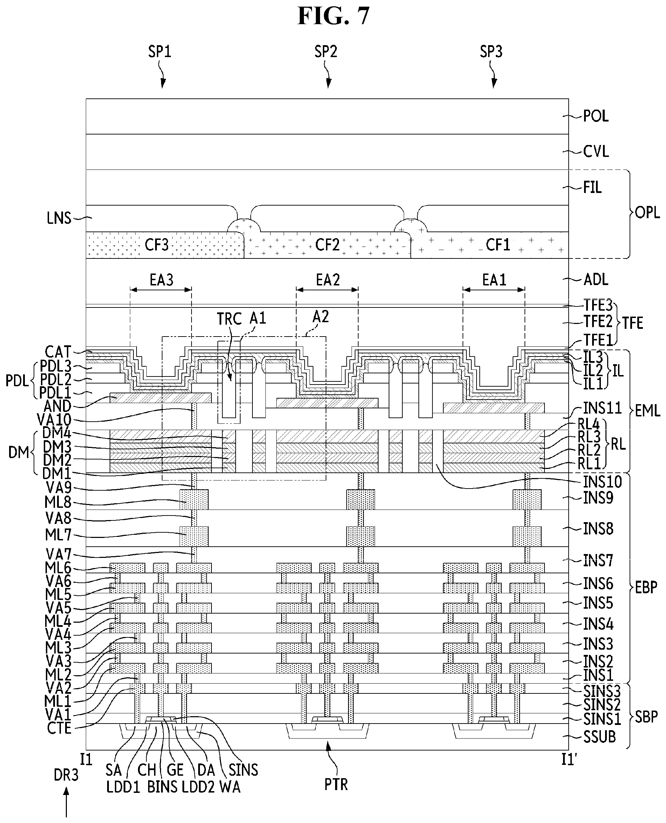

The plurality of pixels PX include a plurality of sub-pixels SP1, SP2, and SP3. The plurality of sub-pixels SP1, SP2, and SP3 may include a plurality of pixel transistors as shown in FIG. 3. The plurality of pixel transistors may be formed by a semiconductor manufacturing process and disposed on a semiconductor substrate SSUB (see FIG. 7). For example, the plurality of pixel transistors of the data driver 700 may be formed of complementary metal oxide semiconductor (CMOS), but the present disclosure is not limited thereto.

Each of the plurality of sub-pixels SP1, SP2, and SP3 may be connected to a write scan line GWL, a control scan line GCL, a bias scan line GBL, a first emission control line ECL1, a second emission control line ECL2, and a data line DL. Each of the plurality of sub-pixels SP1, SP2, and SP3 may receive a data voltage of the data line DL in response to a write scan signal of the write scan line GWL, and emit light from the light emitting element according to the data voltage.

One or more of scan driver 610, the emission driver 620, or the data driver 700 may be disposed in the non-display area NDA.

The scan driver 610 may include a plurality of scan transistors, and the emission driver 620 may include a plurality of light emitting transistors. The plurality of scan transistors and the plurality of light emitting transistors may be formed on the semiconductor substrate SSUB (see FIG. 7) through a semiconductor process. For example, the plurality of scan transistors and the plurality of light emitting transistors may be formed of CMOS, but the present disclosure is not limited thereto.

The scan driver 610 may include a write scan signal output unit 611, a control scan signal output unit 612, and a bias scan signal output unit 613. Each of the write scan signal output unit 611, the control scan signal output unit 612, and the bias scan signal output unit 613 may receive a scan timing control signal SCS from the timing control circuit 400. The write scan signal output unit 611 may generate write scan signals according to the scan timing control signal SCS of the timing control circuit 400 and output them sequentially to the write scan lines GWL. The control scan signal output unit 612 may generate control scan signals in response to the scan timing control signal SCS and sequentially output them to the control scan lines GCL. The bias scan signal output unit 613 may generate bias scan signals according to the scan timing control signal SCS and output them sequentially to the bias scan lines GBL.

The emission driver 620 may include a first emission control driver 621 and a second emission control driver 622. Each of the first emission control driver 621 and the second emission control driver 622 may receive an emission timing control signal ECS from the timing control circuit 400. The first emission control driver 621 may generate first emission control signals according to the emission timing control signal ECS and sequentially output them to the first emission control lines ECL1. The second emission control driver 622 may generate second emission control signals according to the emission timing control signal ECS and sequentially output them to the second emission control lines ECL2.

The data driver 700 may include a plurality of data transistors, and the plurality of data transistors may be formed on the semiconductor substrate SSUB (see FIG. 7) through a semiconductor process. For example, the plurality of data transistors may be formed of CMOS, but the present disclosure is not limited thereto.

The data driver 700 may receive digital video data DATA and a data timing control signal DCS from the timing control circuit 400. The data driver 700 may convert the digital video data DATA into analog data voltages according to the data timing control signal DCS and outputs the analog data voltages to the data lines DL. In this case, the sub-pixels SP1, SP2, and SP3 may be selected by the write scan signal of the scan driver 610, and data voltages may be supplied to the selected sub-pixels SP1, SP2, and SP3.

The heat dissipation layer 200 may overlap the display panel 100 in a third direction DR3, which is a thickness direction of the display panel 100. The heat dissipation layer 200 may be disposed on one surface of the display panel 100, for example, on the rear surface thereof. The heat dissipation layer 200 may dissipate heat generated from the display panel 100. The heat dissipation layer 200 may include a metal layer having high thermal conductivity, such as graphite, silver (Ag), copper (Cu), or aluminum (Al).

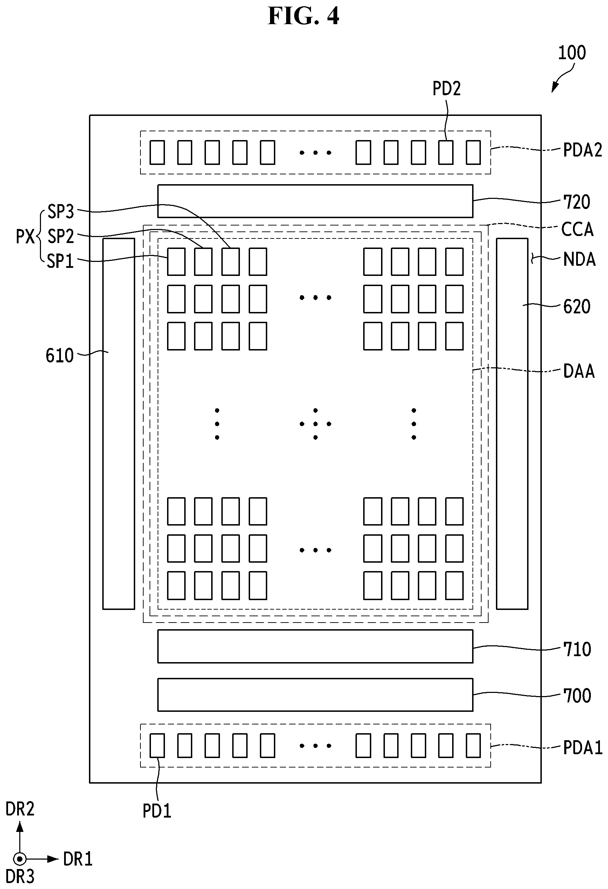

The circuit board 300 may be electrically connected to a plurality of first pads PD1 (see FIG. 4) of a first pad portion PDA1 (see FIG. 4) of the display panel 100 by using a conductive adhesive member such as an anisotropic conductive layer. The circuit board 300 may be a flexible printed circuit board with a flexible material, or a flexible layer. Although the circuit board 300 is illustrated in FIG. 1 as being unfolded, the circuit board 300 may be bent, folded, or rolled. In this case, a first end portion of the circuit board 300 may be disposed on the rear surface of the display panel 100 and/or the rear surface of the heat dissipation layer 200. A second end portion of the circuit board 300 may be connected to the plurality of first pads PD1 (see FIG. 4) of the first pad portion PDA1 (see FIG. 4) of the display panel 100 by using a conductive adhesive member. The first end portion of the circuit board 300 may be an opposite end of the second end portion of the circuit board 300.

The timing control circuit 400 may receive digital video data and timing signals inputted from the outside. The timing control circuit 400 may generate the scan timing control signal SCS, the emission timing control signal ECS, and the data timing control signal DCS for controlling the display panel 100 in response to the timing signals. The timing control circuit 400 may output the scan timing control signal SCS to the scan driver 610, and output the emission timing control signal ECS to the emission driver 620. The timing control circuit 400 may output the digital video data and the data timing control signal DCS to the data driver 700.

The power supply circuit 500 generates a plurality of panel driving voltages. For example, the power supply circuit 500 may generate the plurality of panel driving voltages according to a power voltage from the outside. For example, the power supply circuit 500 may generate a first driving voltage VSS, a second driving voltage VDD, and a third driving voltage VINT and supply them to the display panel 100. The first driving voltage VSS, the second driving voltage VDD, and the third driving voltage VINT are described herein, for example, in connection with FIG. 3.

Each of the timing control circuit 400 and the power supply circuit 500 may be formed as an integrated circuit (IC) and attached to one surface of the circuit board 300. In this case, the scan timing control signal SCS, the emission timing control signal ECS, the digital video data DATA, and the data timing control signal DCS of the timing control circuit 400 may be supplied to the display panel 100 through the circuit board 300. Further, the first driving voltage VSS, the second driving voltage VDD, and the third driving voltage VINT of the power supply circuit 500 may be supplied to the display panel 100 through the circuit board 300.

Alternatively, each of the timing control circuit 400 and the power supply circuit 500 may be disposed in the non-display area NDA of the display panel 100, similar to the scan driver 610, the emission driver 620, and the data driver 700. In this case, the timing control circuit 400 may include a plurality of timing transistors, and the power supply circuit 500 may include a plurality of power transistors. The plurality of timing transistors and the plurality of power transistors may be formed by a semiconductor process and be formed on a semiconductor substrate SSUB (see FIG. 7). For example, the plurality of timing transistors and the plurality of power transistors may be formed as CMOSs, but the present disclosure is not limited thereto. Each of the timing control circuit 400 and the power supply circuit 500 may be disposed between the data driver 700 and the first pad portion PDA1 (see FIG. 4).

FIG. 3 is an equivalent circuit diagram of a first sub-pixel according to an embodiment.

Referring to FIG. 3, a first sub-pixel SP1 may be connected to the write scan line GWL, the control scan line GCL, the bias scan line GBL, the first emission control line ECL1, the second emission control line ECL2, and the data line DL. Further, the first sub-pixel SP1 may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied.

The first sub-pixel SP1 may include a plurality of transistors T1 to T6, a light emitting element LE, a first capacitor CP1, and a second capacitor CP2.

The light emitting element LE emits light in response to a driving current Ids flowing through the channel of a first transistor T1. The emission amount of the light emitting element LE may be proportional to the driving current Ids. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer disposed between the first electrode and the second electrode, but the present disclosure is not limited thereto. For example, the light emitting element LE may be an inorganic light emitting element including a first electrode, a second electrode, and an inorganic semiconductor disposed between the first electrode and the second electrode, in which case the light emitting element LE may be a micro light emitting diode.

The first transistor T1 may be a driving transistor that controls a source-drain current Ids (hereinafter referred to as "driving current") flowing between the source electrode and the drain electrode thereof according to a voltage applied to the gate electrode thereof.

A second transistor T2 may be disposed between one electrode of the first capacitor CP1 and the data line DL. The second transistor T2 is turned on by the write scan signal of the write scan line GWL to connect the one electrode of the first capacitor CP1 to the data line DL. Accordingly, the data voltage of the data line DL may be applied to the one electrode of the first capacitor CP1.

A third transistor T3 may be disposed between a first node N1 and a second node N2. The third transistor T3 is turned on by the write control signal of the write control line GCL to connect the first node N1 to the second node N2. For this reason, when the gate electrode and the source electrode of the first transistor T1 are connected, the first transistor T1 may operate like a diode.

A fourth transistor T4 may be connected between the second node N2 and a third node N3. The fourth transistor T4 is turned on by the first emission control signal of the first emission control line ECL1 to connect the second node N2 to the third node N3. Accordingly, the driving current of the first transistor T1 may be supplied to the light emitting element LE. A fifth transistor T5 may be disposed between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE.

A sixth transistor T6 may be disposed between the source electrode of the first transistor T1 and the second driving voltage line VDL. The sixth transistor T6 is turned on by the second emission control signal of the second emission control line ECL2 to connect the source electrode of the first transistor T1 to the second driving voltage line VDL. Accordingly, the second driving voltage VDD of the second driving voltage line VDL may be applied to the source electrode of the first transistor T1.

The first capacitor CP1 may be formed between the first node N1 and the drain electrode of the second transistor T2. The second capacitor CP2 may be formed between the gate electrode of the first transistor T1 and the second driving voltage line VDL.

Each of the first to sixth transistors T1 to T6 may be a metal-oxide-semiconductor field effect transistor (MOSFET). For example, each of the first to sixth transistors T1 to T6 may be a P-type MOSFET, but the present disclosure is not limited thereto. Each of the first to sixth transistors T1 to T6 may be an N-type MOSFET. Alternatively, some of the first to sixth transistors T1 to T6 may be P-type MOSFETs, and each of the remaining transistors may be an N-type MOSFET.

Although it is illustrated in FIG. 3 that the first sub-pixel SP1 includes six transistors T1 to T6 and two capacitors C1 and C2, it should be noted that the equivalent circuit diagram of the first sub-pixel SP1 is not limited to that shown in FIG. 3. For example, the number of transistors and the number of capacitors of the first sub-pixel SP1 are not limited to those shown in FIG. 3.

Further, the equivalent circuit diagram of the second sub-pixel SP2 and the equivalent circuit diagram of the third sub-pixel SP3 may be substantially the same as the equivalent circuit diagram of the first sub-pixel SP1 described in conjunction with FIG. 3. Therefore, the description of the equivalent circuit diagram of the second sub-pixel SP2 and the equivalent circuit diagram of the third sub-pixel SP3 is not repeated in the present disclosure.

FIG. 4 is a layout diagram illustrating an example of a display panel according to an embodiment.

Referring to FIG. 4, the display area DAA of the display panel 100 according to an embodiment includes the plurality of pixels PX arranged in a matrix form. The non-display area NDA of the display panel 100 according to an embodiment may include the scan driver 610, the emission driver 620, the data driver 700, a first distribution circuit 710, a second distribution circuit 720, the first pad portion PDA1, and a second pad portion PDA2.

The scan driver 610 may be disposed proximate to the first side of the display area DAA, and the emission driver 620 may be disposed proximate to the second side of the display area DAA. For example, the scan driver 610 may be disposed proximate to a first side of the display area DAA in the first direction DR1, and the emission driver 620 may be disposed proximate to a second side of the display area DAA in the first direction DR1. However, the present disclosure is not limited thereto, and the scan driver 610 and the emission driver 620 may be disposed on both the first side and the second side of the display area DAA.

The first pad portion PDA1 may include the plurality of first pads PD1 connected to pads or bumps of the circuit board 300 through a conductive adhesive member. The first pad portion PDA1 may be disposed on the third side of the display area DAA. For example, the first pad portion PDA1 may be disposed on one side of the display area DAA in the second direction DR2. The first pad portion PDA1 may be disposed outside the data driver 700 in the second direction DR2.

The second pad portion PDA2 may include a plurality of second pads PD2 corresponding to inspection pads that test whether the display panel 100 operates normally. The plurality of second pads PD2 may be connected to a jig or a probe pin during an inspection process, or may be connected to a circuit board for inspection. The circuit board for inspection may be a printed circuit board made of a rigid material or a flexible printed circuit board made of a flexible material.

The second pad portion PDA2 may be disposed on the fourth side of the display area DAA. For example, the second pad portion PDA2 may be disposed on the other side of the display area DAA in the second direction DR2. The second pad portion PDA2 may be disposed outside the second distribution circuit 720 in the second direction DR2.

The first distribution circuit 710 distributes data voltages applied through the first pad portion PDA1 to the plurality of data lines DL. For example, the first distribution circuit 710 may distribute the data voltages applied through one first pad PD1 of the first pad portion PDA1 to the P (P is a positive integer of 2 or more) data lines DL, and as a result, the number of the plurality of first pads PD1 may be reduced. At least one first pad PD1 may supply a ground voltage. For example, the ground voltage may be provided to the display panel 100 from a first pad PD1 and through a ground line. The first distribution circuit 710 may be disposed on the third side of the display area DAA of the display panel 100. For example, the first distribution circuit 710 may be disposed on one side of the display area DAA in the second direction DR2.

The second distribution circuit 720 distributes signals applied through the second pad portion PDA2 to the scan driver 610, the emission driver 620, and the data lines DL. The second pad portion PDA2 and the second distribution circuit 720 may be configured to inspect the operation of each of the pixels PX in the display area DAA. The second distribution circuit 720 may be disposed on the fourth side of the display area DAA of the display panel 100. For example, the second distribution circuit 720 may be disposed on the other side of the display area DAA in the second direction DR2.

A cathode connection part CCA may be an area where a second electrode CAT (see FIG. 7) of a display element layer EML (see FIG. 7) is connected to the first driving voltage line VSL of the non-display area NDA. The cathode connection part CCA may be disposed proximate to at least one side of the display area DAA. For example, the cathode connection part CCA may be disposed outside of at least one side of the display area DAA among the left side, right side, upper side, and lower side of the display area DAA. Alternatively, the cathode connection part CCA may be disposed to surround the display area DAA as shown in FIG. 4, which may reduce deviations of the first driving voltage VSS caused by voltage drop (IR drop) or voltage rise (IR rising) of the second electrode CAT in the display area DAA.

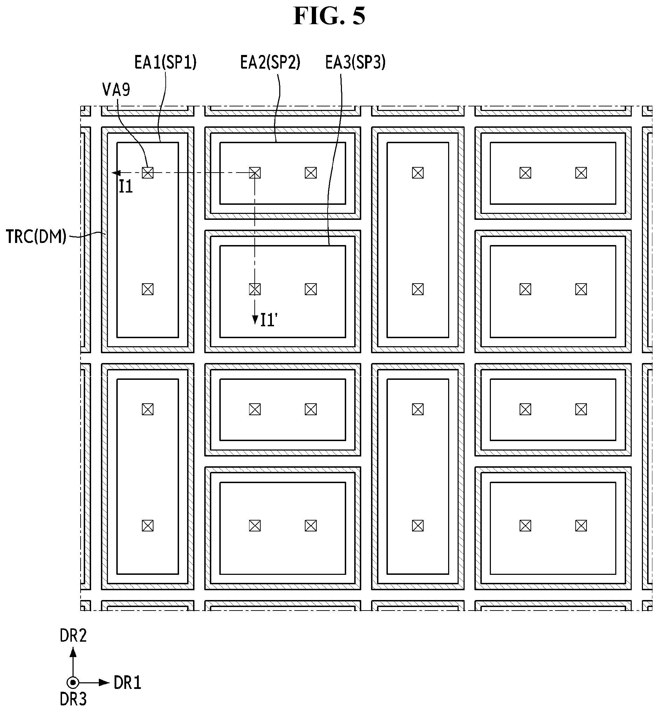

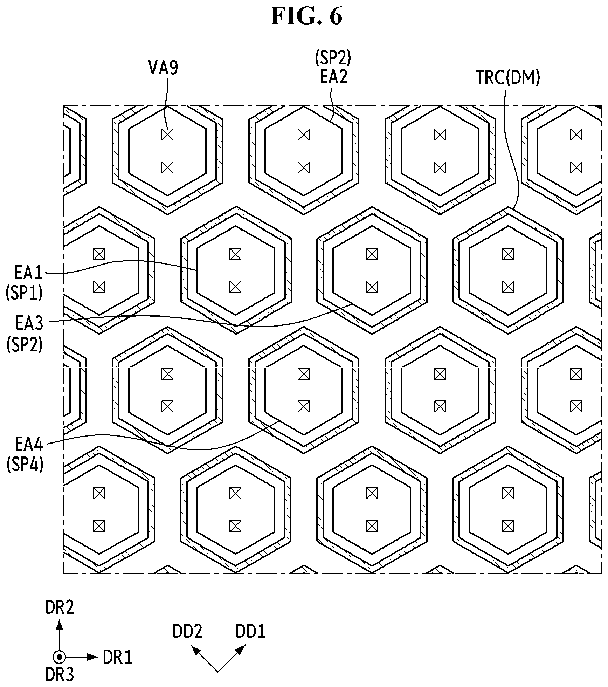

FIG. 5 is a layout diagram illustrating an example of the display area of FIG. 4. FIG. 6 is a layout diagram illustrating another example of the display area of FIG. 4.

Referring to FIG. 5 and FIG. 6, each of the pixels PX may include a first emission area EA1 that is an emission area of the first sub-pixel SP1, a second emission area EA2 that is an emission area of the second sub-pixel SP2, and a third emission area EA3 that is an emission area of the third sub-pixel SP3.

The first emission area EA1, the second emission area EA2, and the third emission area EA3 may have, in plan view, a quadrilateral or hexagonal shape as shown in FIG. 5 and FIG. 6, but the present disclosure is not limited thereto. For example, the first emission area EA1, the second emission area EA2, and the third emission area EA3 may have a polygonal shape other than a quadrangle or hexagon, a circular shape, an elliptical shape, or an atypical shape in plan view.

As shown in FIG. 5, in each of the plurality of pixels PX, the first emission area EA1 and the second emission area EA2 may be adjacent to each other in the first direction DR1. Further, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

Alternatively, as shown in FIG. 6, the emission areas EA1, EA2, EA3, and EA4 may have a hexagonal shape in plan view. In this case, the first emission area EA1 and the third emission area EA3 may be adjacent in the first direction DR1, and the second emission area EA2 and the fourth emission area EA4 may be adjacent in the second direction DR2. Additionally, the first emission area EA1 and the second emission area EA2 may be adjacent in a first diagonal direction DD1, and the second emission area EA2 and the third emission area EA3 may be adjacent in a second diagonal direction DD2. Additionally, the first emission area EA1 and the fourth emission area EA4 may be adjacent in the second diagonal direction DD2, and the third emission area EA3 and the fourth emission area EA4 may be adjacent in the first diagonal direction DD1. The first diagonal direction DD1 may be a direction between the first direction DR1 and the second direction DR2, and may refer to a direction inclined by about 45 degrees with respect to the first direction DR1 and the second direction DR2, and the second diagonal direction DD2 may be a direction perpendicular to the first diagonal direction DD1.

The first sub-pixel SP1 may emit first light, the second sub-pixel SP2 may emit second light, and the third sub-pixel SP3 may emit third light. Here, the first light may be light of a blue wavelength band, the second light may be light of a green wavelength band, and the third light may be light of a red wavelength band. For example, the blue wavelength band may be a wavelength band of light whose main peak wavelength is in the range from about 370 nanometers (nm) to about 460 nm, the green wavelength band may be a wavelength band of light whose main peak wavelength is in the range of approximately 480 nm to 560 nm, and the red wavelength band may be a wavelength band of light whose main peak wavelength is in the range from about 600 nm to about 750 nm. The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" or "approximately" may mean within one or more standard deviations, or within ± 30%, 20%, 10%, 5% of the stated value.

Each of the plurality of pixels PX may include three emission areas EA1, EA2, and EA3 as shown in FIG. 5, or may include four emission areas EA1, EA2, EA3, and EA4 as shown in FIG. 6. In this case, the fourth emission area EA4 may emit the same second light as the second emission area EA2, but the present disclosure is not limited thereto.

The emission areas of the plurality of pixels PX may be disposed in a stripe structure where the emission areas are arranged in the first direction DR1, in one of an RGBG structure or an RGB stripe structure where the emission areas EA1, EA2, EA3, and EA4 may be arranged in a rhombus shape as shown in FIG. 6, or in a hexagonal structure where the emission areas are arranged in a hexagonal shape.

FIG. 7 is a cross-sectional view illustrating an example of a display panel taken along line I1-I1' of FIG. 5.

Referring to FIG. 7, the display panel 100 may include a semiconductor backplane SBP, a light emitting element backplane EBP, the display element layer EML, an encapsulation layer TFE, an optical layer OPL, a cover layer CVL, and a polarizing plate POL.

The semiconductor backplane SBP may include the semiconductor substrate SSUB including a plurality of pixel transistors PTR, a plurality of semiconductor insulating layers covering the plurality of pixel transistors PTR, and a plurality of contact terminals CTE electrically connected to the plurality of pixel transistors PTR, respectively. The plurality of pixel transistors PTR may be the first to sixth transistors T1 to T6 described with reference to FIG. 3.

The semiconductor substrate SSUB may be a silicon substrate, a germanium substrate, or a silicon-germanium substrate. The semiconductor substrate SSUB may be a substrate doped with a first type impurity. A plurality of well regions WA may be disposed on the top surface of the semiconductor substrate SSUB. The plurality of well regions WA may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

Each of the plurality of well regions WA may include a source region SA corresponding to the source electrode of the pixel transistor PTR, a drain region DA corresponding to the drain electrode thereof, and a channel region CH disposed between the source region SA and the drain region DA.

A lower insulating layer BINS may be disposed between a gate electrode GE and the well region WA. A side insulating layer SINS may be disposed on the side surface of the gate electrode GE. The side insulating layer SINS may be disposed on the lower insulating layer BINS.

Each of the source region SA and the drain region DA may be a region doped with the first type impurity. The gate electrode GE of the pixel transistor PTR may overlap the well region WA in the third direction DR3 which is a thickness direction of the semiconductor substrate SSUB. The channel region CH may overlap the gate electrode GE in the third direction DR3. The source region SA may be disposed on a first side of the gate electrode GE, and the drain region DA may be disposed on a second side of the gate electrode GE.

Each of the plurality of well regions WA may further include a first low-concentration impurity region LDD1 disposed between the channel region CH and the source region SA, and a second low-concentration impurity region LDD2 disposed between the channel region CH and the drain region DA. The first low-concentration impurity region LDD1 may be a region having a lower impurity concentration than the source region SA due to the lower insulating layer BINS. The second low-concentration impurity region LDD2 may be a region having a lower impurity concentration than the drain region DA due to the lower insulating layer BINS. The distance between the source region SA and the drain region DA may increase due to the presence of the first low-concentration impurity region LDD1 and the second low-concentration impurity region LDD2, and thus, the length of the channel region CH of each of the pixel transistors PTR may increase.

A first semiconductor insulating layer SINS1 may be disposed on the semiconductor substrate SSUB. A second semiconductor insulating layer SINS2 may be disposed on the first semiconductor insulating layer SINS1.

The plurality of contact terminals CTE may be disposed on the second semiconductor insulating layer SINS2. Each of the plurality of contact terminals CTE may be connected to any one of the gate electrode GE, the source region SA, or the drain region DA of each of the pixel transistors PTR through a hole penetrating the first semiconductor insulating layer SINS1 and the second semiconductor insulating layer INS2. The plurality of contact terminals CTE may be formed of one or more of copper (Cu), aluminum (Al), tungsten (W), molybdenum (Mo), chromium (Cr), gold (Au), titanium (Ti), nickel (Ni), or neodymium (Nd), or an alloy thereof.

A third semiconductor insulating layer SINS3 may be disposed on a side surface of each of the plurality of contact terminals CTE. The top surface of each of the plurality of contact terminals CTE may be exposed without being covered by the third semiconductor insulating layer SINS3.

Each of the first semiconductor insulating layer SINS1, the second semiconductor insulating layer SINS2, and the third semiconductor insulating layer SINS3 may formed of silicon carbonitride (SiCN) or a silicon oxide (SiOx)-based inorganic layer, but the present disclosure is not limited thereto.

The semiconductor substrate SSUB may be replaced with a glass substrate or a polymer resin substrate such as polyimide. In this case, thin layer transistors may be disposed on the glass substrate or the polymer resin substrate. The glass substrate may be a rigid substrate that does not bend, and the polymer resin substrate may be a flexible substrate that can be bent or curved.

The light emitting element backplane EBP may include a plurality of conductive layers ML1 to ML8, a plurality of vias VA1 to VA9, and a plurality of insulating layers INS1 to INS9. In addition, the light emitting element backplane EBP may include a plurality of insulating layers INS1 to INS9 disposed between the first to eighth conductive layers ML1 to ML8.

The first to eighth insulating layers INS1 to INS9 may insulate the first to eighth conductive layers ML1 to ML8. The first to eighth conductive layers ML1 to ML8 may connect the plurality of contact terminals CTE exposed from the semiconductor backplane SBP to implement the circuit of the first sub-pixel SP1 shown in FIG. 3.

For example, the first to sixth transistors T1 to T6 may be formed in the semiconductor backplane SBP, and the connection of the first to sixth transistors T1 to T6 and the first and second capacitors C1 and C2 may be accomplished through the first to eighth conductive layers ML1 to ML8. In addition, the connection between the drain region corresponding to the drain electrode of the fourth transistor T4, the source region corresponding to the source electrode of the fifth transistor T5, and a first electrode AND of the light emitting element LE may be accomplished through the first to eighth conductive layers ML1 to ML8.

The first to eighth conductive layers ML1 to ML8 and the first to eighth vias VA1 to VA8 may be formed of substantially the same material. The first to eighth conductive layers ML1 to ML8 and the first to eighth vias VA1 to VA8 may be formed of one or more of copper (Cu), aluminum (Al), tungsten (W), molybdenum (Mo), chromium (Cr), gold (Au), titanium (Ti), nickel (Ni), or neodymium (Nd), or an alloy thereof. The first to eighth vias VA1 to VA8 may be made of substantially the same material. First to eighth insulating layers INS1 to INS8 may be formed of a silicon oxide (SiOx)-based inorganic layer, but embodiments of the present disclosure are not limited thereto.

A ninth insulating layer INS9 may be disposed on the eighth insulating layer INS8 and the eighth conductive layer ML8. The ninth insulating layer INS9 may be formed of a silicon oxide (SiOx)-based inorganic layer, but embodiments of the present disclosure are not limited thereto.

Each of the ninth vias VA9 may penetrate the ninth insulating layer INS9 and be connected to the exposed eighth conductive layer ML8. The ninth vias VA9 may be formed of one or more of copper (Cu), aluminum (Al), tungsten (W), molybdenum (Mo), chromium (Cr), gold (Au), titanium (Ti), nickel (Ni), or neodymium (Nd), or an alloy thereof.

The display element layer EML may be disposed on the light emitting element backplane EBP. The display element layer EML may include a tenth insulating layer INS10, an eleventh insulating layer INS11, a reflective electrode RL, first electrodes AND, a light emitting stack IL, a second electrode CAT, a pixel defining layer PDL, a plurality of trenches TRC, and a plurality of dummy electrodes DM.

The reflective electrode RL may be disposed on the ninth insulating layer INS9. The reflective electrode RL may include at least one reflective electrode RL1, RL2, RL3, or RL4. For example, the reflective electrode RL may include first to fourth reflective electrodes RL1, RL2, RL3, and RL4 as illustrated in FIG. 7.

The first reflective electrodes RL1 may be disposed on the ninth insulating layer INS9, and may be connected to the ninth via VA9. Each of the second reflective electrodes RL2 may be disposed on the corresponding first reflective electrode RL1. Each of the third reflective electrodes RL3 may be disposed on the corresponding second reflective electrode RL2. Each of the fourth reflective electrodes RL4 may be disposed on the corresponding third reflective electrode RL3.

According to an embodiment, the second reflective electrodes RL2 may be electrodes configured for reflecting light from the light emitting elements LE, and a thickness of the second reflective electrode RL2 may be greater than a thickness of the first reflective electrode RL1, a thickness of the third reflective electrode RL3, and a thickness of the fourth reflective electrode RL4.

Each of the first reflective electrodes RL1 may be made of one or more of copper (Cu), aluminum (Al), tungsten (W), molybdenum (Mo), chromium (Cr), gold (Au), titanium (Ti), nickel (Ni), or neodymium (Nd), or alloys thereof. For example, each of the first reflective electrodes RL1 may include titanium nitride (TiN), each of the second reflective electrodes RL2 may include aluminum (Al), each of the third reflective electrodes RL3 may include titanium nitride (TiN), and each of the fourth reflective electrodes RL4 may include titanium (Ti).

The tenth insulating layer INS10 may be disposed on the ninth insulating layer INS9. The tenth insulating layer INS10 may be disposed between the neighboring reflective electrodes RL. The tenth insulating layer INS10 may be a layer for planarizing steps due to the reflective electrodes RL. The eleventh insulating layer INS11 may be disposed on the tenth insulating layer INS10 and the reflective electrode RL.

The tenth insulating layer INS10 and the eleventh insulating layer INS11 may be formed of a silicon oxide (SiOₓ)-based inorganic layer, but embodiments of the present disclosure are not limited thereto. According to an embodiment, the tenth insulating layer INS10 and the eleventh insulating layer INS11 may be formed by a same process or by different processes. For example, the tenth insulating layer INS10 and the eleventh insulating layer INS11 may simultaneously deposited.

The eleventh insulating layer INS11 may be an optical auxiliary layer for adjusting a resonance distance of light emitted from the light emitting stack IL in at least one sub-pixel among the first sub-pixel SP1, the second sub-pixel SP2, or the third sub-pixel SP3. The thickness of the eleventh insulating layer INS11 may be different in the first sub-pixel SP1, the second sub-pixel SP2, and the third sub-pixel SP3. That is, in order to adjust a distance from the reflective electrode RL to the second electrode CAT according to a main wavelength of light emitted from each of the first sub-pixel SP1, the second sub-pixel SP2, and the third sub-pixel SP3, the thickness of the eleventh insulating layer INS11 may be set in each of the first sub-pixel SP1, the second sub-pixel SP2, and the third sub-pixel SP3.

For example, as illustrated in FIG. 7, the thickness of the eleventh insulating layer INS11 in the first sub-pixel SP1 may be greater than the thickness of the eleventh insulating layer INS11 in the second sub-pixel SP2, and the thickness of the eleventh insulating layer INS11 in the second sub-pixel SP2 may be greater than the thickness of the eleventh insulating layer INS11 in the third sub-pixel SP3. In this case, the distance between the first electrode AND and the reflective electrode RL in the first sub-pixel SP1 may be greater than the distance between the first electrode AND and the reflective electrode RL in the second sub-pixel SP2. In addition, the distance between the first electrode AND and the reflective electrode RL in the second sub-pixel SP2 may be greater than the distance between the first electrode AND and the reflective electrode RL in the third sub-pixel SP3.

Each of the tenth vias VA10 may penetrate the eleventh insulating layer INS11 and be connected to the exposed fourth reflective electrodes RL4. The tenth vias VA10 may be formed of one or more of copper (Cu), aluminum (Al), tungsten (W), molybdenum (Mo), chromium (Cr), gold (Au), titanium (Ti), nickel (Ni), or neodymium (Nd), or an alloy thereof. The thickness of the tenth via VA10 in the first sub-pixel SP1 may be greater than the thickness of the tenth via VA10 in the second sub-pixel SP2, and the thickness of the tenth via VA10 in the second sub-pixel SP2 may be greater than the thickness of the tenth via VA10 in the third sub-pixel SP3.

The first electrode AND of each of the light emitting elements LE may be disposed on the eleventh insulating layer INS11 and may be connected to the tenth via VA10. The first electrode AND of each of the light emitting elements LE may be connected to the drain region DA or the source region SA of the pixel transistor PTR through the tenth via VA10, the reflective electrode RL, the first to ninth vias VA1 to VA9, the first to eighth conductive layers ML1 to ML8, and the contact terminal CTE. The first electrode AND of each of the light emitting elements LE may be made of one or more of copper (Cu), aluminum (Al), tungsten (W), molybdenum (Mo), chromium (Cr), gold (Au), titanium (Ti), nickel (Ni), or neodymium (Nd), or an alloy thereof. For example, the first electrode AND of each of the light emitting elements LE may be made of titanium nitride (TiN).

The pixel defining layer PDL may be disposed on a partial area of the first electrode AND of each of the light emitting elements LE. The pixel defining layer PDL may cover an edge of the first electrode AND of each of the light emitting elements LE. The pixel defining layer PDL may partition the first emission areas EA1, the second emission areas EA2, and the third emission areas EA3. Each of the first emission area EA1, the second emission area EA2, and the third emission area EA3 may be an area where the light emitting element LE including a first electrode AND, a light emitting stack IL, and a second electrode CAT is disposed.

The first emission area EA1 may be defined as an area in which the first electrode AND, the light emitting stack IL, and the second electrode CAT are sequentially stacked in the first sub-pixel SP1 to emit light. The second emission area EA2 may be defined as an area in which the first electrode AND, the light emitting stack IL, and the second electrode CAT are sequentially stacked in the second sub-pixel SP2 to emit light. The third emission area EA3 may be defined as an area in which the first electrode AND, the light emitting stack IL, and the second electrode CAT are sequentially stacked in the third sub-pixel SP3 to emit light.

The pixel defining layer PDL may include first to third pixel defining layers PDL1, PDL2, and PDL3. The first pixel defining layer PDL1 may be disposed on the edge of the first electrode AND of each of the light emitting elements LE, the second pixel defining layer PDL2 may be disposed on the first pixel defining layer PDL1, and the third pixel defining layer PDL3 may be disposed on the second pixel defining layer PDL2. The first pixel defining layer PDL1, the second pixel defining layer PDL2, and the third pixel defining layer PDL3 may be formed of a silicon oxide (SiOₓ)-based inorganic layer. Alternatively, the first pixel defining layer PDL1 and the third pixel defining layer PDL3 may be formed of a silicon nitride (SiNx)-based inorganic layer, while the second pixel defining layer PDL2 may be formed of a silicon oxide (SiOₓ)-based inorganic layer. The first pixel defining layer PDL1, the second pixel defining layer PDL2, and the third pixel defining layer PDL3 may each have a thickness of about 500 Å.

In order to reduce or prevent the likelihood of the first encapsulation inorganic layer TFE1 being cut off due to the step coverage, the first pixel defining layer PDL1, the second pixel defining layer PDL2, and the third pixel defining layer PDL3 may have a cross-sectional structure having a stepped portion. Step coverage refers to the ratio of the degree of thin layer coated on an inclined portion to the degree of thin layer coated on a flat portion. The lower the step coverage, the more likely it is that the thin layer will be cut off at inclined portions.

Each of the plurality of trenches TRC may penetrate through the first pixel defining layer PDL1, the second pixel defining layer PDL2, and the third pixel defining layer PDL3. In each of the plurality of trenches TRC, the eleventh insulating layer INS11 may have a shape in which at least a portion thereof is trenched.

At least one trench TRC may be disposed between the neighboring sub-pixels SP1, SP2, and SP3. Although FIG. 7 illustrates that two trenches TRC are disposed between adjacent sub-pixels SP1, SP2, and SP3, embodiments of the present disclosure are not limited thereto.

In plan view as illustrated in FIG. 5 and FIG. 6, the trench TRC may have a closed curved shape proximate to the emission area. For example, the plurality of trenches TRC may include a trench TRC surrounding at least a portion of the first emission area EA1, a trench TRC surrounding the second emission area EA2, and a trench TRC surrounding the third emission area EA3. For example, as illustrated in FIG. 5 and FIG. 6 the plurality of trenches TRC may include a trench TRC surrounding the first emission area EA1, a trench TRC surrounding the second emission area EA2, and a trench TRC surrounding the third emission area EA3.

The light emitting stack IL may include a plurality of stack layers IL1, IL2, and IL3. It has been illustrated in FIG. 7 that the light emitting stack IL has a three-tandem structure including a first stack layer IL1, a second stack layer IL2, and a third stack layer IL3, but embodiments of the present disclosure are not limited thereto. For example, the light emitting stack IL may have a two-tandem structure including two stack layers.

In the three-tandem structure, the light emitting stack IL may have a tandem structure including a plurality of stack layers IL1, IL2, and IL3 emitting different light. For example, the light emitting stack IL may include a first stack layer IL1 emitting light of a first color, a second stack layer IL2 emitting light of a second color, and a third stack layer IL3 emitting light of a third color. The first stack layer IL1, the second stack layer IL2, and the third stack layer IL3 may be sequentially stacked.

The first stack layer IL1 may have a structure in which a first hole transporting layer, a first light emitting layer emitting the light of the first color, and a first electron transporting layer may be sequentially stacked. The second stack layer IL2 may have a structure in which a second hole transporting layer, a second light emitting layer emitting the light of the second color, and a second electron transporting layer may be sequentially stacked. The third stack layer IL3 may have a structure in which a third hole transporting layer, a third organic light emitting layer emitting the light of the third color, and a third electron transporting layer may be sequentially stacked.

A first charge generation layer for supplying charges to the second stack layer IL2 and supplying electrons to the first stack layer IL1 may be disposed between the first stack layer IL1 and the second stack layer IL2. The first charge generation layer may include an N-type charge generation layer supplying electrons to the first stack layer IL1 and a P-type charge generation layer supplying holes to the second stack layer IL2. The N-type charge generation layer may include a dopant of a metal material.

A second charge generation layer for supplying charges to the third stack layer IL3 and supplying electrons to the second stack layer IL2 may be disposed between the second stack layer IL2 and the third stack layer IL3. The second charge generation layer may include an N-type charge generation layer supplying electrons to the second stack layer IL2 and a P-type charge generation layer supplying holes to the third stack layer IL3.

The first stack layer IL1 may be disposed on the first electrodes AND, and the pixel defining layer PDL. A residual layer RINS disposed on the bottom surface of the trench TRC in each of the trenches TRC may be the same material as the first stack layer IL1. For example, a portion of the material used to form the first stack layer IL1 may be disposed on the bottom surface of each of the trenches TRC. Due to the trenches TRC, the first stack layer IL1 may be disconnected between the sub-pixels SP1, SP2, and SP3 neighboring to each other. The second stack layer IL2 may be disposed on the first stack layer IL1. Due to the trenches TRC, the second stack layer IL2 may be disconnected between the sub-pixels SP1, SP2, and SP3 neighboring to each other. For example, a portion of the residual layer RINS disposed on the bottom surface of the trench TRC in each of the trenches TRC may be the same material as the second stack layer IL2. A cavity ES or an empty space may be disposed between the residual layer RINS and the second stack layer IL2. The third stack layer IL3 may be disposed on the second stack layer IL2. The third stack layer IL3 may not be disconnected by the trenches TRC, and may be disposed to cover the second stack layer IL2 in each of the trenches TRC.

In the three-tandem structure, each of the plurality of trenches TRC may be a structure for disconnecting the first to third hole transporting layers of each of the first to third stack layers IL1 to IL3, the first charge generation layer, and the second charge generation layer of the display element layer EML between sub-pixels SP1, SP2, and SP3 neighboring to each other. In addition, in the two-tandem structure, each of the plurality of trenches TRC may be a structure for disconnecting a charge generation layer disposed between a lower stack layer and an upper stack layer and the lower stack layer.

In order to electrically disconnect the first and second stack layers IL1 and IL2 of the display element layer EML between the sub-pixels SP1, SP2, and SP3 neighboring to each other, a height of each of the plurality of trenches TRC may be greater than a height of the pixel defining layer PDL. The height of each of the plurality of trenches TRC refers to a length of each of the plurality of trenches TRC in the third direction DR3. The height of the pixel defining layer PDL refers to a length of the pixel defining layer PDL in the third direction DR3. In order to disconnect the hole transporting layers and the charge generation layers of the light emitting stack IL of the display element layer EML between the sub-pixels SP1, SP2, and SP3 neighboring to each other, other structures may exist instead of the trenches TRC. For example, instead of the trenches TRC, partition walls having a reverse tapered shape may be disposed on the pixel defining layer PDL. For example, the first and second stack layers IL1 and IL2 of the display element layer EML between the sub-pixels SP1, SP2, and SP3 neighboring to each other may be reliably disconnected, and a leakage current (e.g., side leakage current) between the neighboring sub-pixels may be reduced or eliminated.

It has been illustrated in FIG. 7 that the light emitting stack IL are all disposed in the first emission area EA1, the second emission area EA2, and the third emission area EA3, but embodiments of the present disclosure are not limited thereto. For example, instead of the light emitting stack IL, a first light emitting layer may be disposed in the first emission area EA1, and may not be disposed in the second emission area EA2 and the third emission area EA3. In addition, a second light emitting layer may be disposed in the second emission area EA2, and may not be disposed in the first emission area EA1 and the third emission area EA3. Moreover, a third light emitting layer may be disposed in the third emission area EA3, and may not be disposed in the first emission area EA1 and the second emission area EA2. In this case, first to third color filters CF1, CF2, and CF3 of the optical layer OPL may be omitted.

The second electrode CAT may be disposed on the light emitting stack IL. The second electrode CAT may be disposed on the third stack layer IL3 in each of the plurality of trenches TRC. The second electrode CAT may be made of a transparent conductive material (TCO) such as indium tin oxide (ITO) or indium zinc oxide (IZO) capable of transmitting light therethrough. The second electrode CAT may be made of a semi-transmissive conductive material such as magnesium (Mg) or silver (Ag), or an alloy of magnesium (Mg) and silver (Ag), which may transmit a first portion of light therethrough and may filter a second portion of the light. When the second electrode CAT is made of the semi-transmissive conductive material, light emission efficiency of each of the first to third sub-pixels SP1, SP2, and SP3 may be increased by the use of micro cavities disposed in the semi-transmissive conductive material.

The encapsulation layer TFE may be disposed on the display element layer EML. The encapsulation layer TFE may include at least one inorganic layer TFE1 or TFE3 to inhibit or prevent oxygen or moisture from permeating into the display element layer EML. For example, a first encapsulation inorganic layer TFE1 may be disposed on the second electrode CAT, and a second encapsulation inorganic layer TFE3 may be disposed on the first encapsulation inorganic layer TFE1. Each of the first encapsulation inorganic layer TFE1 and the second encapsulation inorganic layer TFE3 may be formed as a multilayer in which one or more inorganic layers selected from silicon nitride (SiNx), silicon oxy nitride (SiON), silicon oxide (SiOx), titanium oxide (TiOx), and aluminum oxide (AlOx) are alternately stacked.

In addition, the encapsulation layer TFE may include at least one organic layer TFE2 to protect the display element layer EML from foreign substances such as dust. For example, the encapsulation organic layer TFE2 may be disposed between the first encapsulation inorganic layer TFE1 and the second encapsulation inorganic layer TFE3. The encapsulation organic layer TFE2 may be a monomer. Alternatively, the encapsulation organic layer TFE2 may be an organic layer such as acryl resin, epoxy resin, phenolic resin, polyamide resin, polyimide resin or the like.

An adhesive layer ADL may be a layer for bonding the encapsulation layer TFE to the optical layer OPL. The adhesive layer ADL may be a double-sided adhesive member. In addition, the adhesive layer ADL may be a transparent adhesive member such as a transparent adhesive or a transparent adhesive resin.

The optical layer OPL may include a plurality of color filters CF1, CF2, and CF3, a plurality of lenses LNS, and a filling layer FIL. The plurality of color filters CF1, CF2, and CF3 may include the first to third color filters CF1, CF2, and CF3. The first to third color filters CF1, CF2, and CF3 may be disposed on the adhesive layer ADL.

The first color filter CF1 may overlap the first emission area EA1 of the first sub-pixel SP1. The first color filter CF1 may transmit light of the first color, i.e., light of a blue wavelength band. The blue wavelength band may be a range including light from about 370 nm to about 460 nm. Thus, the first color filter CF1 may transmit light of the first color among light emitted from the first emission area EA1.

The second color filter CF2 may overlap the second emission area EA2 of the second sub-pixel SP2. The second color filter CF2 may transmit light of the second color, i.e., light of a green wavelength band. The green wavelength band may be a range including light from about 480 nm to about 560 nm. Thus, the second color filter CF2 may transmit light of the second color among light emitted from the second emission area EA2.

The third color filter CF3 may overlap the third emission area EA3 of the third sub-pixel SP3. The third color filter CF3 may transmit light of the third color, i.e., light of a red wavelength band. The red wavelength band may be a range including light from about 600 nm to about 750 nm. Thus, the third color filter CF3 may transmit light of the third color among light emitted from the third emission area EA3.

The plurality of lenses LNS may be disposed on the first color filter CF1, the second color filter CF2, and the third color filter CF3, respectively. Each of the plurality of lenses LNS may be a structure for increasing the proportion of light directed to the front of the display device 10. Each of the plurality of lenses LNS may have a cross-sectional shape that is convex in an upward direction.

The filling layer FIL may be disposed on the plurality of lenses LNS. The filling layer FIL may have a predetermined refractive index such that light travels in the third direction DR3 at an interface between the filling layer FIL and the plurality of lenses LNS. In an example, the filling layer FIL may be a planarization layer. The filling layer FIL may be an organic layer such as acrylic resin, epoxy resin, phenolic resin, polyamide resin, or polyimide resin.

The cover layer CVL may be disposed on the filling layer FIL. The cover layer CVL may be a glass substrate or a polymer resin. When the cover layer CVL is a glass substrate, the cover layer CVL may be attached onto the filling layer FIL. In this case, the filling layer FIL may serve to bond the cover layer CVL. When the cover layer CVL is a glass substrate, the cover layer CVL may serve as an encapsulation substrate. When the cover layer CVL is a polymer resin, the cover layer CVL may be directly applied onto the filling layer FIL.

The polarizing plate POL may be disposed on one surface of the cover layer CVL. The polarizing plate POL may be a structure for reducing or preventing visibility degradation caused by reflection of external light. The polarizing plate POL may include a linear polarizing plate POL and a phase retardation layer. For example, the phase retardation layer may be a λ/4 plate (quarter-wave plate), but the present disclosure is not limited thereto. However, when visibility degradation caused by reflection of external light is sufficiently overcome by the first to third color filters CF1, CF2, and CF3, the polarizing plate POL may be omitted.

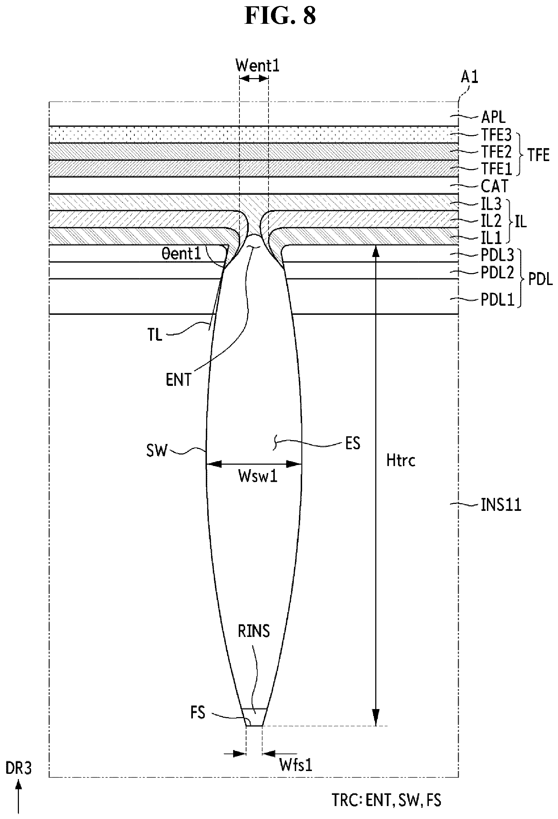

FIG. 8 is a cross-sectional view illustrating an example of area A1 of FIG. 7 in detail.

Referring to FIG. 8, the trench TRC may be a structure for disconnecting the charge generation layer between the first stack layer IL1 and the second stack layer IL2. The trench TRC may be defined by a cavity that, at least partially or entirely, penetrates the pixel defining layer PDL. At least a portion of the trench TRC may be recessed in the eleventh insulating layer INS11. The trench TRC may be formed by a lithography process, for example, using argon fluoride (ArF) as a photoresist.

The trench TRC may include an entrance ENT, a sidewall SW, and a bottom surface FS.

The entrance ENT of the trench TRC may be an open area at the top of the trench TRC defined by the third pixel defining layer PDL3. The entrance ENT of the trench TRC may be covered by the light emitting stack IL. For example, the first stack layer IL1 and the second stack layer IL2 may be sequentially disposed at the edge of the entrance ENT of the trench TRC. The entrance ENT of the trench TRC exposed without being covered by the first stack layer IL1 and the second stack layer IL2 may be covered by the third stack layer IL3.

The sidewall SW of the trench TRC may be a side surface that connects the entrance ENT of the trench TRC to the bottom surface FS thereof. The sidewall SW of the trench TRC may be defined by the eleventh insulating layer INS11 and the pixel defining layer PDL. The length of the sidewall SW of the trench TRC defined by the eleventh insulating layer INS11 may be greater than the length of the sidewall SW of the trench TRC defined by the pixel defining layer PDL.

The bottom surface FS of the trench TRC may be a closed area at the bottom of the trench TRC defined by the eleventh insulating layer INS11. The residual layer RINS, which may be made of the same material as the first stack layer IL1, may be disposed on the bottom surface FS of the trench TRC.

A height Htrc of the trench TRC may be defined as a distance from the bottom surface FS of the trench TRC to the entrance ENT of the trench TRC in the third direction DR3. The height Htrc of the trench TRC may be a maximum distance from the bottom surface FS of the trench TRC to the entrance ENT of the trench TRC in the third direction DR3. In order to disconnect each of the first and second stack layers IL1 and IL2, including the first charge generation layer and the second charge generation layer thereof, the height Htrc of the trench TRC may range from approximately 6,000 Å to approximately 10,000 Å. In this case, the height of the pixel defining layer PDL may be approximately 1,500 Å. For example, the sum of the thickness of the first pixel defining layer PDL1, the thickness of the second pixel defining layer PDL2, and the thickness of the third pixel defining layer PDL3 may be smaller than or equal to 1/4 of the height Htrc of the trench TRC.

In addition, the first to second stack layers IL1 and IL2 may each be disconnected, wherein an angle θent1 formed between a tangent TL of the sidewall SW of the trench TRC and the top surface of the third pixel defining layer PDL3 at the entrance of the trench TRC may range from about 80° to about 90°. The disconnection in the first to second stack layers IL1 and IL2 may include a disconnection of the first charge generation layer and the second charge generation layer thereof. Accordingly, a width Wsw1 of the trench TRC in one direction at the center of the sidewall SW may be larger than a width Went1 of the entrance ENT in one direction and a width Wfs1 of the bottom surface FS in one direction. For example, the width Wsw1 of the trench TRC may be a maximum width. That is, each of the trenches TRC may have a jar-shaped cross section.

Further, each of the trenches TRC may cut off the first to second stack layers IL1 and IL2, including the first charge generation layer and the second charge generation layer of the first to second stack layers IL1 and IL2. The width Went1 of the entrance ENT of the trench TRC may be larger than about 100 nm and smaller than about 130 nm. Additionally, the width Wfs1 of the bottom surface of the trench TRC in one direction may be smaller than the width Went1 of the entrance ENT of the trench TRC in one direction.

The first stack layer IL1 and the second stack layer IL2 may be sequentially disposed at the edge of the entrance ENT of each trench TRC. The first stack layer IL1 may be disposed closer to the edge of the entrance ENT of each trench TRC than the second stack layer IL2. The third stack layer IL3 may be disposed to cover the remaining part of the entrance ENT of each trench TRC, which is not covered by the first stack layer IL1 and the second stack layer IL2.

According to an embodiment, the encapsulation layer TFE may further include a transparent conductive oxide (e.g., IZO) and an aluminum oxide (e.g., Al₂O₃) in addition to the inorganic layer and the organic layer. Therefore, a moisture permeation prevention function and sealing power of the encapsulation layer TFE may be improved. In particular, the display device 10 including the trench TRC may have a structure susceptible to moisture permeation from the outside through the void ES (for example, a void in micro units) generated by the trench TRC. However, the encapsulation layer TFE of an embodiment may inhibit or prevent such moisture permeation through the void ES.

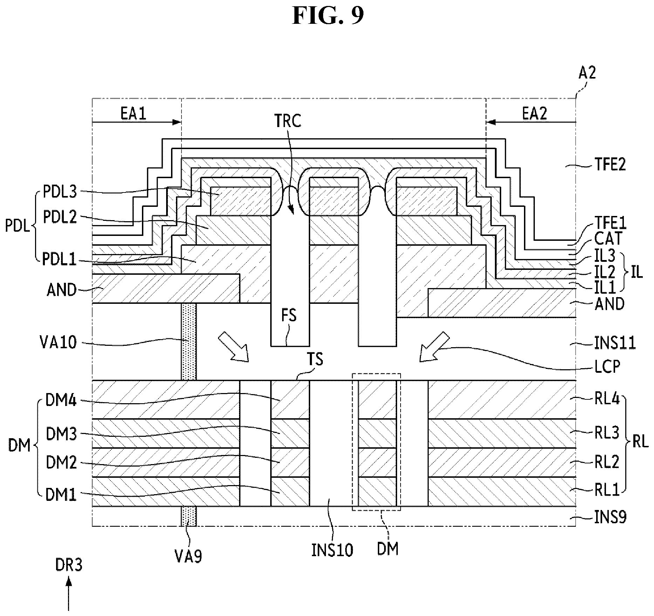

FIG. 9 is a cross-sectional view illustrating an example of area A2 of FIG. 7 in detail.

The dummy electrode DM may be disposed between the substrate (e.g., a semiconductor substrate SSUB) and the trench TRC of the pixel defining layer PDL and may be between the plurality of first electrodes AND. This may reduce a leakage current (e.g., side leakage current) between adjacent sub-pixels (between the plurality of first electrodes AND). For example, the dummy electrode DM may be disposed on the ninth insulating layer INS9 to overlap the trench TRC.

The dummy electrode DM may include one or more dummy electrodes DM1, DM2, DM3, DM4. For example, the dummy electrode DM may include a plurality of dummy electrodes DM1, DM2, DM3, DM4 stacked on the ninth insulating layer INS9. For example, the dummy electrode DM may include a first dummy electrode DM1, a second dummy electrode DM2, a third dummy electrode DM3, and a fourth dummy electrode DM4 as shown in FIG. 7 or FIG. 9.

The first dummy electrode DM1 may be disposed on the ninth insulating layer INS9. The second dummy electrode DM2 may be disposed on the first dummy electrode DM1. The third dummy electrode DM3 may be disposed on the second dummy electrode DM2. The fourth dummy electrode DM4 may be disposed on the third dummy electrode DM3.

Dummy electrodes adjacent to each other in the third direction DR3 may be connected to each other. For example, dummy electrodes adjacent to each other may be in contact (or in direct contact) with each other. Specifically, the first dummy electrode DM1 and the second dummy electrode DM2 may be in contact (or in direct contact) with each other, the second dummy electrode DM2 and the third dummy electrode DM3 may be in contact (or in direct contact) with each other, and the third dummy electrode DM3 and fourth dummy electrode DM4 may be in contact (or in direct contact) with each other.

The thickness of the second dummy electrode DM2 may be greater than the thickness of the first dummy electrode DM1, the thickness of the third dummy electrode DM3, and the thickness of the fourth dummy electrode DM4. Here, the thickness may be the size in the third direction DR3.

The dummy electrode DM and the trench TRC may be spaced apart from each other by a predetermined distance. For example, a top surface TS of the dummy electrode DM and the bottom surface FS of the trench TRC may be spaced apart from each other by a predetermined distance. Specifically, the top surface TS of the fourth dummy electrode DM4 disposed on the uppermost layer and the bottom surface FS of the trench TRC may be spaced apart from each other by a predetermined distance. At this time, the eleventh insulating layer INS11 may be disposed between the dummy electrode DM and the trench TRC. For example, the eleventh insulating layer INS11 may be disposed between the top surface TS of the dummy electrode DM and the bottom surface FS of the trench TRC.

As illustrated in FIG. 8, when the residual layer RINS is disposed on the bottom surface FS of the trench TRC, the dummy electrode DM may face the residual layer RINS. For example, the dummy electrode DM may overlap the residual layer RINS in the trench TRC in the third direction DR3. At this time, the dummy electrode DM and the residual layer RINS may be spaced apart from each other by a predetermined distance.

The first dummy electrode DM1 may be formed of one or more of copper (Cu), aluminum (Al), tungsten (W), molybdenum (Mo), chromium (Cr), gold (Au), titanium (Ti), nickel (Ni), or neodymium (Nd), or an alloy thereof. For example, the first dummy electrode DM1 may contain titanium nitride (TiN), the second dummy electrode DM2 may contain aluminum (Al), the third dummy electrode DM3 may contain titanium nitride (TiN), and the fourth dummy electrode DM4 may contain titanium (Ti).

The dummy electrode DM may be disposed on the same layer as the reflective electrode RL described herein. For example, the dummy electrode DM and the reflective electrode RL may be disposed on the ninth insulating layer INS9. The dummy electrode DM may be formed of the same material as the reflective electrode RL. For example, a material including one or more layers may be deposited and patterned to simultaneously form the dummy electrode DM and the reflective electrode RL. According to an embodiment, the dummy electrode DM and the reflective electrode RL may be formed separately on the ninth insulating layer INS9. For example, the dummy electrode DM and the reflective electrode RL may be formed of the same material or different materials, and may include the same number of layers or a different number of layers.

The first dummy electrode DM1 may be disposed on the same layer as the first reflective electrode RL1, the second dummy electrode DM2 may be disposed on the same layer as the second reflective electrode RL2, the third dummy electrode DM3 may be disposed on the same layer as the third reflective electrode RL3, and the fourth dummy electrode DM4 may be disposed on the same layer as the fourth reflective electrode RL4. Embodiments are not limited thereto, and the dummy electrode DM and the reflective electrode RL may each include one to three layers, or more than four layers.

The first dummy electrode DM1 may be formed of the same material as the first reflective electrode RL1, the second dummy electrode DM2 may be formed of the same material as the second reflective electrode RL2, the third dummy electrode DM3 may be formed of the same material as the third reflective electrode RL3, and the fourth dummy electrode DM4 may be formed of the same material as the fourth reflective electrode RL4.

The first dummy electrode DM1 and the first reflective electrode RL1 may be formed together by the same process, the second dummy electrode DM2 and the second reflective electrode RL2 may be formed together by the same process, the third dummy electrode DM3 and the third reflective electrode RL3 may be formed together by the same process, and the fourth dummy electrode DM4 and the fourth reflective electrode RL4 may be formed together by the same process.

The dummy electrode DM may overlap the trench TRC. For example, the dummy electrode DM may overlap trench TRC in the third direction DR3. The dummy electrode DM may be disposed between the ninth insulating layer INS9 and the trench TRC. This may provide charge collection of charges by the dummy electrode DM for leakage current reduction. The top surface TS of the dummy electrode DM may face the bottom surface FS of the trench TRC. For example, the top surface TS of the fourth dummy electrode DM4 disposed on the uppermost layer of the dummy electrode DM may face the bottom surface FS of the trench TRC.

In plan view as illustrated in FIG. 5 or FIG. 6, the dummy electrode DM may have a closed curved shape surrounding the emission area. This may reduce leakage current reduction between adjacent sub-pixels (first electrodes AND) in more than one direction. For example, the plurality of dummy electrodes DM may include a dummy electrode DM surrounding the first emission area EA1, a dummy electrode DM surrounding the second emission area EA2, and a dummy electrode DM surrounding the third emission area EA3. Each of the dummy electrodes DM may include the first dummy electrode DM1, the second dummy electrode DM2, the third dummy electrode DM3, and the fourth dummy electrode DM4 stacked along the third direction DR3 as described herein.

In plan view, the dummy electrode DM may be disposed along the trench TRC. In plan view, the dummy electrode DM may have the same shape as the trench TRC. For example, in plan view, the dummy electrode DM and the trench TRC may each have a closed curved shape surrounding the emission area.

Power (e.g., constant power) may be applied to the dummy electrode DM. For example, power (e.g., constant power) may be applied to the dummy electrode DM by the power supply circuit 500. Here, the power may include at least one of voltage (e.g., constant voltage) or current (constant current). To this end, for example, the dummy electrode DM may be connected to the power supply circuit 500. According to an embodiment, at least one dummy electrode among the plurality of dummy electrodes DM1, DM2, DM3, and DM4 included in one dummy electrode DM may be connected to the power supply circuit 500. As another example, the dummy electrode DM may be connected to a ground GND. For example, at least one of the plurality of dummy electrodes DM1, DM2, DM3, or DM4 included in one dummy electrode DM may be connected to the ground GND.

The voltage applied to the dummy electrode DM may be smaller than the voltage applied to the first electrode AND. In this case, the dummy electrode DM may be connected to the ground GND.

As another example, the voltage applied to the dummy electrode DM may be the same as the first driving voltage VSS. In this case, the dummy electrode DM may be connected to the first driving voltage line VSL.

As another example, the voltage applied to the dummy electrode DM may be the same as the third driving voltage VINT. In this case, the dummy electrode DM may be connected to the third driving voltage line VIL.

According to an embodiment, the dummy electrode DM may be disposed between substrate SSUB and trench TRC (e.g. adjacently disposed to the trench TRC), and accordingly, leakage current (e.g., side leakage current) between the neighboring sub-pixels may be reduced.

As described herein, the light emitting stack IL (e.g., the charge generation layer of the light emitting stack IL) may be disconnected by the trench TRC, and accordingly, a path of the leakage current between the neighboring sub-pixels (e.g., the first sub-pixel SP1 including the first emission area EA1 and the second sub-pixel SP2 including the second emission area EA2) may be blocked. However, when the width of the trench TRC is small, a leakage current between the neighboring sub-pixels may occur through a disconnection in the light emitting stack IL. According to an embodiment, the path of the leakage current through the disconnection in the light emitting stack IL may be changed by the dummy electrode DM. For example, at least a portion of a leakage current between adjacent sub-pixels may flow through the dummy electrode DM with relatively low resistance on the trench TRC. For example, a greater portion of leakage current from adjacent sub-pixels may flow through the dummy electrode DM with relatively low resistance on the trench TRC than between the adjacent sub-pixels. In other words, due to an electric field generated around the dummy electrode DM to which the power is applied, charges (e.g., charges of leakage current) from the light emitting stack IL (e.g., the disconnected charge generation layer) on the trench TRC may flow to the dummy electrode DM through the pixel defining layer PDL and the eleventh insulating layer INS11. According to an embodiment, the dummy electrode DM may define a leakage current path LCP. The leakage current path LCP may extend from the light emitting stack IL to the dummy electrode DM. Further, the leakage current path LCP may extend from the first electrodes AND disposed below adjacent ones of the light emitting stacks IL to the dummy electrode DM. As described herein, due to the electric field from the dummy electrode DM, charges of leakage current from the light emitting stack IL may follow the leakage current path LCP and may be collected in the dummy electrode DM, and the leakage current between the neighboring sub-pixels may be reduced. Accordingly, color mixing phenomenon between the neighboring sub-pixels may be reduced or prevented and an image quality of the display device 10 may be improved.

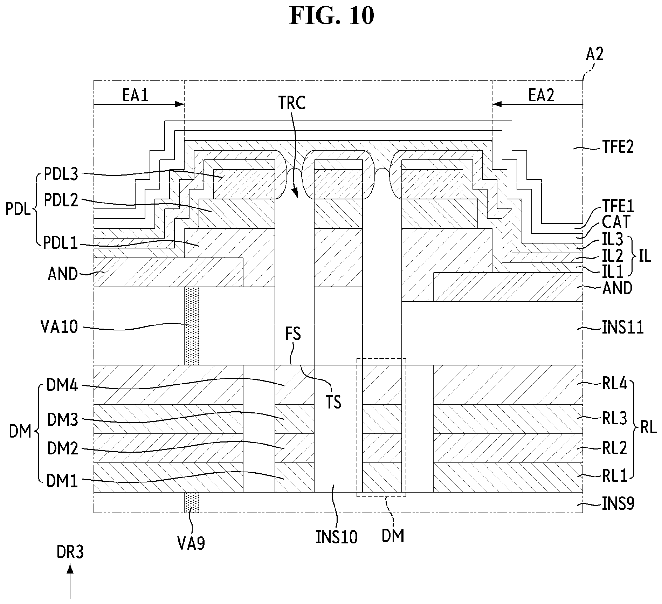

FIG. 10 is a cross-sectional view of a display device 10 according to another embodiment. For example, FIG. 10 is a cross-sectional view illustrating another example of area A2 of FIG. 7.

The display device 10 of FIG. 10 is different from the display device 10 of FIG. 9 described herein in the shape of the trench TRC, and the difference will be mainly described as follows.

As illustrated in FIG. 10, the trench TRC may be connected to the dummy electrode DM. For example, the trench TRC and the dummy electrode DM may be in contact with each other. Accordingly, the bottom surface FS of the trench TRC may be substantially the top surface TS of the dummy electrode DM. In other words, the top surface TS of the dummy electrode DM may define the bottom surface FS of the trench TRC. For example, the top surface TS of the fourth dummy electrode DM4 disposed on the uppermost layer of the dummy electrode DM may be the bottom surface FS of the trench TRC.

In FIG. 10, the dummy electrode DM may be facilitated (e.g. used) as an etch stop layer defining the depth (e.g., the size in a reverse direction of the third direction DR3 (hereinafter, a third reverse direction)) of the trench TRC. For example, after forming the dummy electrode DM, the trench TRC may be formed as the first pixel defining layer PDL1, the second pixel defining layer PDL2, and the third pixel defining layer PDL3 are etched (e.g., dry-etched), and at this time, the etching of the pixel defining layers PDL1, PDL2, and PDL3 may be stopped at the dummy electrode DM including a metal material.

As illustrated in FIG. 8, when the residual layer RINS is disposed on the bottom surface FS of the trench TRC, the dummy electrode DM may face the residual layer RINS. For example, the dummy electrode DM may overlap the residual layer RINS inside the trench TRC in the third direction DR3. For example, the residual layer RINS inside the trench TRC may be disposed on the dummy electrode DM. For example, the dummy electrode DM and the residual layer RINS may be in contact (or in direct contact) with each other.

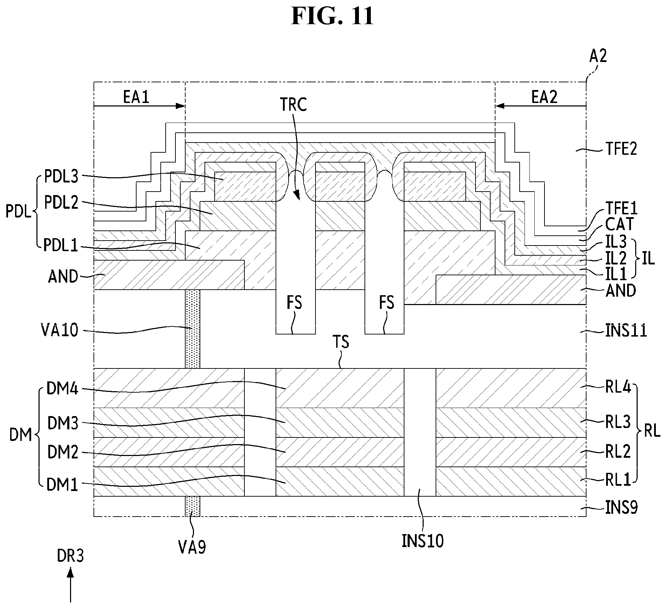

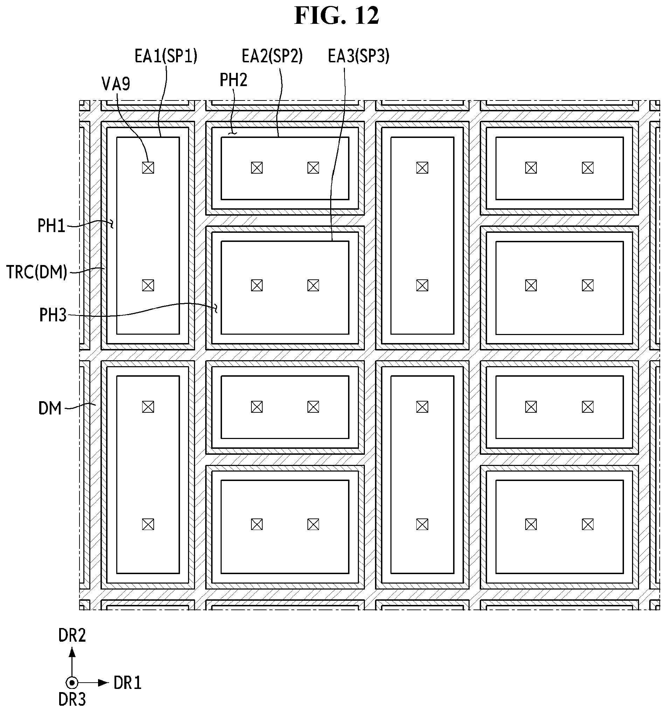

FIG. 11 is a cross-sectional view of a display device 10 according to still another embodiment. For example, FIG. 11 may be a cross-sectional view illustrating still another example of area A2 of FIG. 7. FIG. 12 is a diagram for explaining a planar shape of the dummy electrode DM of FIG. 11.

The display devices 10 of FIG. 11 and FIG. 12 are different from the display device 10 of FIG. 9 described herein in the shape of the dummy electrode DM, and the difference will be mainly described as follows.

As illustrated in FIG. 11, the dummy electrode DM may overlap the neighboring plurality of trenches TRC. For example, the dummy electrode DM may overlap two neighboring trenches TRC in the third direction DR3. This may increase an effect of collection of charges by the dummy electrode DM. Specifically, both edges of the dummy electrode DM may overlap the bottom surfaces FS of the two trenches TRC, respectively. The edges of the top surface TS of the dummy electrode DM excluding the central portion may overlap the bottom surfaces FS of the two trenches TRC, respectively. Meanwhile, the central portion of the dummy electrode DM may not overlap the trenches TRC.

The dummy electrode DM and the two trenches TRC may be spaced apart from each other by a predetermined distance. For example, the top surface TS of the dummy electrode DM and the bottom surfaces FS of the two trenches TRC may be spaced apart from each other by a predetermined distance. Specifically, the top surface TS of the fourth dummy electrode DM4 disposed on the uppermost layer of the dummy electrode DM and the bottom surfaces FS of the two trenches TRC may be spaced apart from each other by a predetermined distance.

In plan view as illustrated in FIG. 12, the dummy electrode DM may surround the trenches TRC. At this time, the edges of the dummy electrode DM may overlap the trenches TRC. Meanwhile, the central portion of the dummy electrode DM may not overlap the trenches TRC, and may be disposed between the neighboring trenches TRC.

In plan view as illustrated in FIG. 12, the dummy electrode DM may have a through hole overlapping the emission area. For example, the dummy electrode DM may include a first through hole PH1, a second through hole PH2, and a third through hole PH3 penetrating the dummy electrode DM in the third direction DR3. The first through hole PH1 may overlap the first emission area EA1, the second through hole PH2 may overlap the second emission area EA2, and the third through hole PH3 may overlap the third emission area EA3. According to an embodiment, in plan view, the first through hole PH1 may surround the first emission area EA1, the second through hole PH2 may surround the second emission area EA2, and the third through hole PH3 may surround the third emission area EA3. According to an embodiment, in plan view, the size of the first through hole PH1 may be greater than the first emission area EA1, the size of the second through hole PH2 may be greater than the second emission area EA2, and the size of the third through hole PH3 may be greater than the third emission area EA3.

As illustrated in FIG. 8, when the residual layer RINS is disposed on the bottom surface FS of each trench TRC, the dummy electrode DM may face the residual layers RINS. For example, the dummy electrode DM may overlap the residual layers RINS in the trench TRC in the third direction DR3. At this time, the dummy electrode DM and the residual layer RINS may be spaced apart from each other by a predetermined distance.

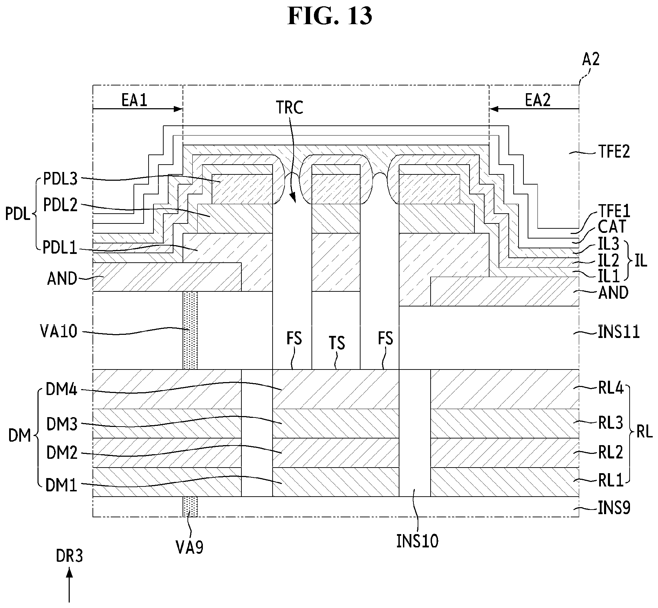

FIG. 13 is a cross-sectional view of a display device 10 according to still another embodiment. For example, FIG. 13 is a cross-sectional view illustrating still another example of area A2 of FIG. 7.

The display device 10 of FIG. 13 is different from the display device 10 of FIG. 11 described herein in the shape of the dummy electrode DM, and the difference will be mainly described as follows.

As illustrated in FIG. 13, the neighboring trenches TRC may be connected to the dummy electrode DM. For example, the trenches TRC may be in contact with the dummy electrode DM. Accordingly, each bottom surface FS of the trenches TRC may be substantially the top surface TS of the dummy electrode DM. In other words, the top surface TS of the dummy electrode DM may define each bottom surface FS of the trenches TRC. For example, the top surface TS of the fourth dummy electrode DM4 disposed on the uppermost layer of the dummy electrode DM may be each bottom surface FS of the trenches TRC.

In FIG. 13, the dummy electrode DM may be facilitated as an etch stop layer defining each depth (e.g., the size in the third reverse direction) of the trenches TRC. For example, after forming the dummy electrode DM, the trenches TRC may be formed as the first pixel defining layer PDL1, the second pixel defining layer PDL2, and the third pixel defining layer PDL3 are etched (e.g., dry-etched), and at this time, the etching of the pixel defining layers PDL1, PDL2, and PDL3 may be stopped at the dummy electrode DM including a metal material.

As illustrated in FIG. 8, when the residual layer RINS is disposed on the bottom surface FS of each trench TRC, the dummy electrode DM may face the residual layers RINS. For example, the dummy electrode DM may overlap the residual layers RINS inside the trench TRC in the third direction DR3. For example, the residual layers RINS inside each of the trenches TRC may be disposed on the dummy electrode DM. For example, the dummy electrode DM and the residual layers RINS may be in contact (or in direct contact) with each other.

Meanwhile, plan view of the display device 10 of FIG. 13 may be substantially the same as FIG. 12 described herein. In other words, the planar shape of the dummy electrode DM of FIG. 13 and the planar shape of the trenches TRC of FIG. 13 may be respectively the same as the planar shape of the dummy electrode DM of FIG. 12 and the planar shape of the trenches TRC of FIG. 12.

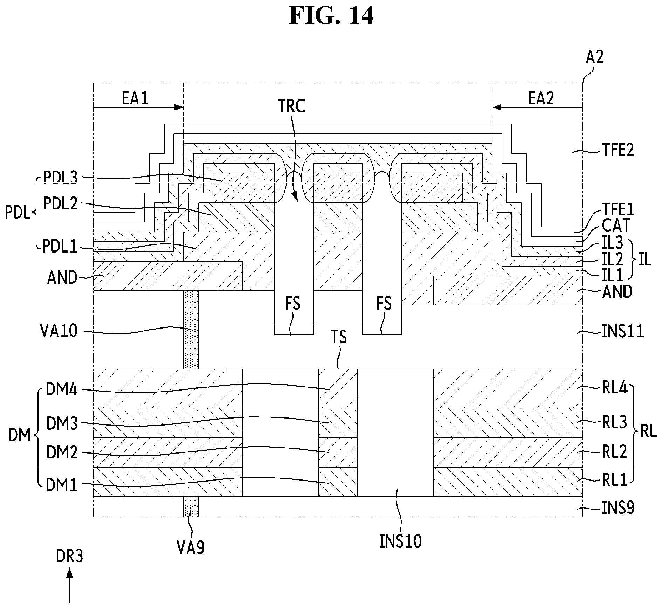

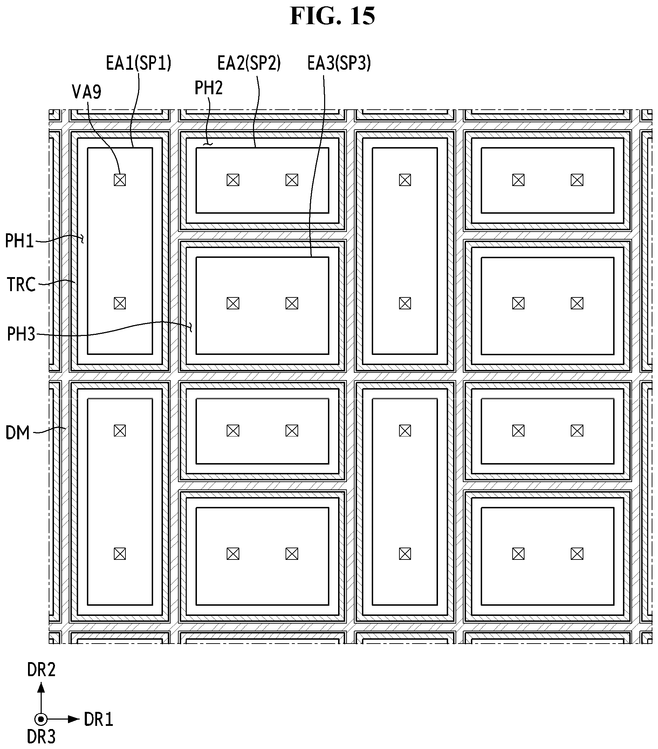

FIG. 14 is a cross-sectional view of a display device according to still another embodiment. For example, FIG. 14 is a cross-sectional view illustrating still another example of area A2 of FIG. 7. FIG. 15 is a diagram for explaining a planar shape of a dummy electrode DM of FIG. 14.

The display devices 10 of FIG. 14 and FIG. 15 may be different from the display device 10 of FIG. 9 in the shape of the dummy electrode DM, and the difference will be mainly described as follows.

As illustrated in FIG. 14, the dummy electrode DM may not overlap the trenches TRC. For example, the dummy electrode DM may not overlap the trenches TRC in the third direction DR3. Instead, the dummy electrode DM may overlap the pixel defining layer PDL defining the trenches TRC and the eleventh insulating layer INS11.

In plan view as illustrated in FIG. 15, the dummy electrode DM may be disposed between the neighboring trenches TRC.

In plan view as illustrated in FIG. 15, the dummy electrodes DM may surround the trenches TRC.

In plan view as illustrated in FIG. 15, the dummy electrode DM may have a through hole overlapping the emission area. For example, the dummy electrode DM may include a first through hole PH1, a second through hole PH2, and a third through hole PH3 penetrating the dummy electrode DM in the third direction DR3. The first through hole PH1 may overlap the first emission area EA1, the second through hole PH2 may overlap the second emission area EA2, and the third through hole PH3 may overlap the third emission area EA3. According to an embodiment, in plan view, the first through hole PH1 may surround the first emission area EA1, the second through hole PH2 may surround the second emission area EA2, and the third through hole PH3 may surround the third emission area EA3. According to an embodiment, in plan view, the size of the first through hole PH1 may be greater than the first emission area EA1, the size of the second through hole PH2 may be greater than the second emission area EA2, and the size of the third through hole PH1 may be greater than the third emission area EA3.

As illustrated in FIG. 8, when the residual layer RINS is disposed on the bottom surface FS of each trench TRC, the dummy electrode DM may face the residual layer RINS. For example, the dummy electrode DM may overlap the residual layers RINS in the trench TRC in the third direction DR3. At this time, the dummy electrode DM and the residual layer RINS may be spaced apart from each other by a predetermined distance.

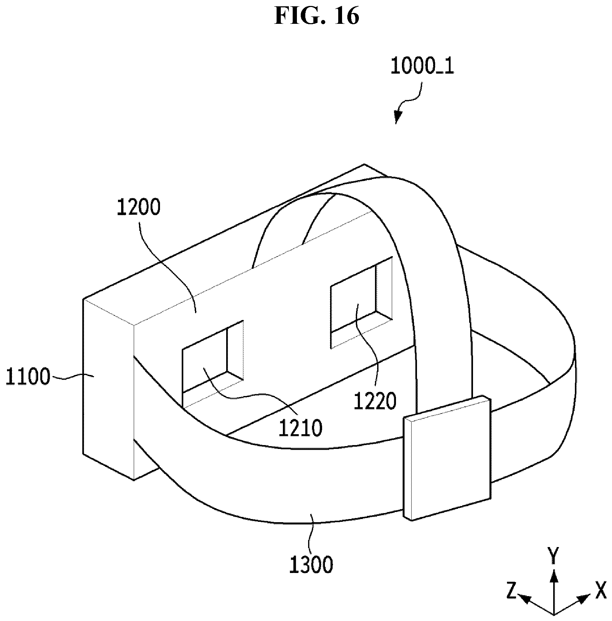

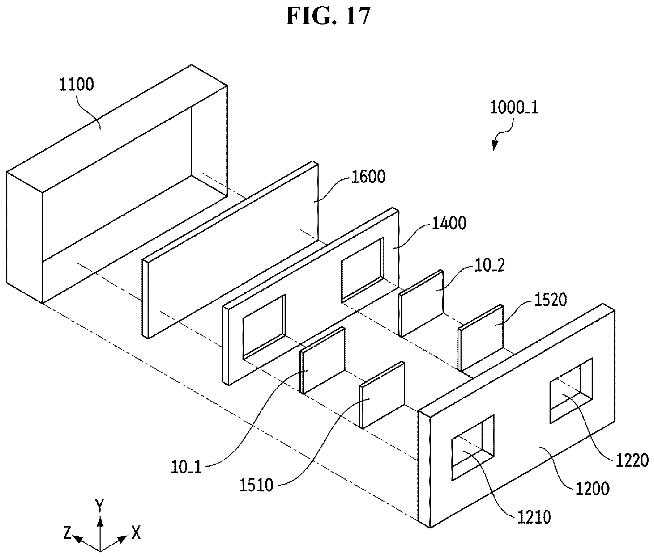

FIG. 16 is a perspective view illustrating a head mounted display device according to an embodiment. FIG. 17 is an exploded perspective view illustrating an example of the head mounted display device of FIG. 16.

Referring to FIG. 16 and FIG. 17, a head mounted display 1000_1 according to an embodiment may include a first display device 10_1, a second display device 10_2, a display device housing 1100, a housing cover 1200, a first eyepiece 1210, a second eyepiece 1220, a head mounted band 1300, a middle frame 1400, a first optical member 1510, a second optical member 1520, and a control circuit board 1600.

The first display device 10_1 provides an image to the user's left eye, and the second display device 10_2 provides an image to the user's right eye. Since each of the first display device 10_1 and the second display device 10_2 is substantially the same as the display device 10 described in conjunction with FIGS. 1 to 15, description of the first display device 10_1 and the second display device 10_2 will be omitted.

The first optical member 1510 may be disposed between the first display device 10_1 and the first eyepiece 1210. The second optical member 1520 may be disposed between the second display device 10_2 and the second eyepiece 1220. Each of the first optical member 1510 and the second optical member 1520 may include at least one convex lens.

The middle frame 1400 may be disposed between the first display device 10_1 and the control circuit board 1600 and between the second display device 10_2 and the control circuit board 1600. The middle frame 1400 serves to support and fix the first display device 10_1, the second display device 10_2, and the control circuit board 1600.

The control circuit board 1600 may be disposed between the middle frame 1400 and the display device housing 1100. The control circuit board 1600 may be connected to the first display device 10_1 and the second display device 10_2 through the connector. The control circuit board 1600 may convert an image source inputted from the outside into the digital video data DATA, and transmit the digital video data DATA to the first display device 10_1 and the second display device 10_2 through the connector.

The control circuit board 1600 may transmit the digital video data DATA corresponding to a left-eye image optimized for the user's left eye to the first display device 10_1, and may transmit the digital video data DATA corresponding to a right-eye image optimized for the user's right eye to the second display device 10_2. Alternatively, the control circuit board 1600 may transmit the same digital video data DATA to the first display device 10_1 and the second display device 10_2.

The display device housing 1100 serves to accommodate the first display device 10_1, the second display device 10_2, the middle frame 1400, the first optical member 1510, the second optical member 1520, and the control circuit board 1600. The housing cover 1200 is disposed to cover one open surface of the display device housing 1100. The housing cover 1200 may include the first eyepiece 1210 at which the user's left eye is located and the second eyepiece 1220 at which the user's right eye is located. FIGS. 16 and 17 illustrate that the first eyepiece 1210 and the second eyepiece 1220 are disposed separately, but the present disclosure is not limited thereto. The first eyepiece 1210 and the second eyepiece 1220 may be combined into one.

The first eyepiece 1210 may be aligned with the first display device 10_1 and the first optical member 1510, and the second eyepiece 1220 may be aligned with the second display device 10_2 and the second optical member 1520. Therefore, the user may view, through the first eyepiece 1210, the image of the first display device 10_1 magnified as a virtual image by the first optical member 1510, and may view, through the second eyepiece 1220, the image of the second display device 10_2 magnified as a virtual image by the second optical member 1520.

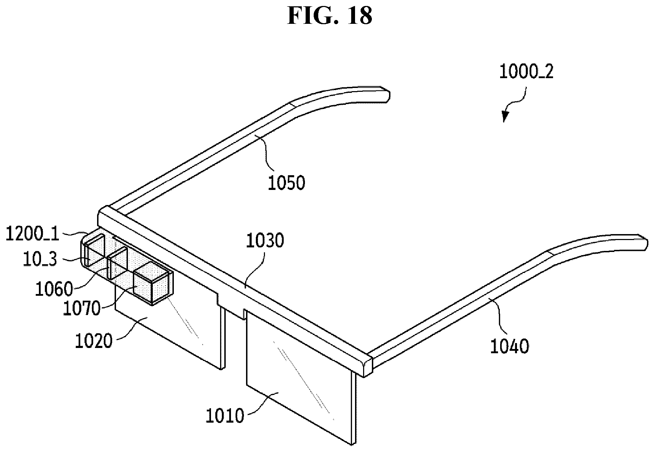

The head mounted band 1300 serves to secure the display device housing 1100 to the user's head such that the first eyepiece 1210 and the second eyepiece 1220 of the housing cover 1200 remain located on the user's left and right eyes, respectively. When the housing cover 1200 is implemented to be lightweight and compact, the head mounted display 1000_1 may be provided with an eyeglass frame as shown in FIG. 18 instead of the head mounted band 1300.

In addition, the head mounted display 1000_1 may further include a battery for supplying power, an external memory slot for accommodating an external memory, and an external connection port and a wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

FIG. 18 is a perspective view illustrating a head mounted display device according to an embodiment.

Referring to FIG. 18, a head mounted display 1000_2 according to an embodiment may be an eyeglasses-type display device in which a display device housing 1200_1 is implemented in a lightweight and compact manner. The head mounted display 1000_2 according to an embodiment may include a display device 10_3, a left eye lens 1010, a right eye lens 1020, a support frame 1030, temples 1040 and 1050, an optical member 1060, an optical path changing member 1070, and the display device housing 1200_1.

The display device housing 1200_1 may include the display device 10_3, the optical member 1060, and the optical path changing member 1070. The image displayed on the display device 10_3 may be magnified by the optical member 1060, and may be provided to the user's right eye through the right eye lens 1020 after the optical path thereof is changed by the optical path changing member 1070. As a result, the user may view an augmented reality image, through the right eye, in which a virtual image displayed on the display device 10_3 and a real image seen through the right eye lens 1020 may be combined. For example, the real image may be an image of an actual scene or environment that may be captured by a camera.

FIG. 18 illustrates that the display device housing 1200_1 is disposed at the right end portion of the support frame 1030, but embodiments of the present specification are not limited thereto. For example, the display device housing 1200_1 may be disposed at the left end portion of the support frame 1030, and in this case, the image of the display device 10_3 may be provided to the user's left eye. Alternatively, the display device housing 1200_1 may be disposed at both the left and right ends of the support frame 1030, and in this case, the user may view the image displayed on the display device 10_3 through both the left and right eyes.

The display device according to an embodiment can be applied to various electronic devices. The electronic device according to an embodiment may include the display device described herein and may further include modules or devices having additional functions in addition to the display device.

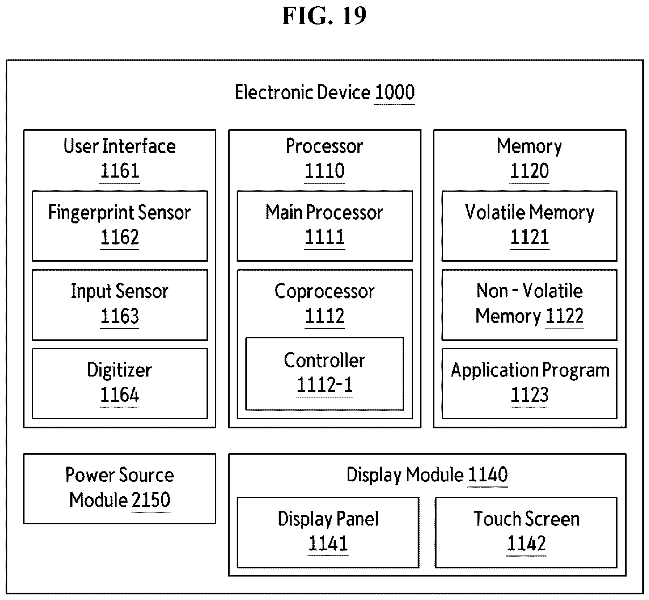

FIG. 19 is a block diagram of an electronic device according to an embodiment. Referring to FIG. 19, the electronic device 1000 according to an embodiment may output various information (e.g., images, text, music, etc.) through a display module 1140, which, for example, may correspond to the display device 10 shown in FIG. 1. When a processor 1110 executes an application stored in a memory 1120, the display module 1140 may provide application information to a user through a display panel 1141.

In some embodiments, the electronic device 1000 may be configured as a smartphone, camera, smart TV, monitor, smartwatch, tablet, automotive display, or AR/VR headset. For example, the electronic device 1000 may be a smartphone including a touch-sensitive display area DA for interaction and a non-display area NDA including sensors and circuits for enhanced functionality. For example, the electronic device 1000 may be a television or monitor including a large display area DA for high-resolution video playback and a non-display area NDA incorporating driving circuits or connectivity modules for external inputs. For example, the electronic device 1000 may be a smartwatch including a display area DA optimized for compact and high-clarity visuals and a non-display area NDA integrating biometric sensors for health monitoring. In some cases, the electronic device 1000 be an AR/VR headset.

In some embodiments, memory 1120 may store information such as software codes for operating an application program 1123. The application program 1123 may include a software designed to execute specific tasks or provide functionality to a user. The application program 1123 may operate under the control of the processor 1110 and utilizes data stored in the memory 1120 to deliver a wide range of features, such as productivity tools, multimedia streaming and playback, file or mail deliveries or communication services. The application program 1123 interacts seamlessly with the user interface 1161 or touch screen 1142, allowing a user to launch, navigate, and utilize the program through user inputs such as touch, tap, gesture, or voice interaction.

Upon user selection of an application via touch screen 1142 or user interface 1161, the processor 1110 may execute the application program 1123 corresponding to the selected application retrieved from the memory 1120 to perform functionalities of the application. For example, when a user selects a camera application by tapping the icon (or a camera application icon) presented on the display panel 1141, the processor 1110 activates a camera module. The processor 1110 may transmit image data corresponding to a captured image acquired through the camera module to the display module 1140. The display module 1140 may display an image corresponding to the captured image through the display panel 1141.

As another example, when a user wishes to make a phone call, the user taps the telephone icon displayed on the display module 1140, the processor 1110 may execute a phone application program stored in the memory 1120. A telephone keypad may be presented on the display panel 1141 for the user to enter a phone number to call.

As another example, the display module 1140 may be integrated into an electronic device 1000, such as a laptop computer, smart TV, or tablet. A user wishing to access a multimedia streaming application (e.g., to watch a music video or movie) can do so by tapping the corresponding icon. This action activates the application, allowing the user to view the streamed content.

The processor 1110 may include a main processor 1111 and an auxiliary or coprocessor 1112. The main processor 1111 may include a central processing unit (CPU). The main processor 1111 may further include one or more of a graphics processing unit (GPU), a communication processor (CP), and an image signal processor (ISP).

The coprocessor 1112 may include a controller 1112-1. The controller 1112-1 may include an interface conversion circuit and a timing control circuit. The controller 1112-1 may receive an image signal from the main processor 1111, convert the data format of the image signal to match the interface specifications with the display module 1140, and output image data. The controller 1112-1 may output various control signals to drive the display module 1140. For example, the controller 1112-1 may drive the display module 1140 to display the icon on the display screen suitable for selection by a user to cause execution of an application program 1123.

The memory 1120 may store one or more application programs 1123 and various data used by at least one component (for example, the processor 1110 or the user interface 1161) of the electronic device 1000 and input data or output data for commands related thereto. For example, a camera application program, a GPS application program, an augmented reality and virtual reality application program, and other application programs that can be executed by the processor 1110 upon selection of corresponding icons presented on the display screen (or display panel 1141) via the touch screen 1142 or user interface 1161 by the user. In addition, various setting data corresponding to user settings may be stored in the memory 1120. The memory 1120 may include volatile memory 1121 and non-volatile memory 1122.

The display module 1140 may output visual information (images) to the user. The display module 1140 may include the display panel 1141, a gate driver, the source driver, a voltage generation circuit, and a touch screen 1142. The display module 1140 may further include a window, a chassis, and a bracket to protect the display panel 1141. The display module 1140 may include at least a part of the configuration of the display device 10 shown in FIG. 1.

The user interface 1161 serves as the interaction medium between a user and the electronic device 1000. The user interface 1161 may detect an input by a part (e.g., finger) of a user's body or an input by a pen or a mouse, and generate an electric signal or data value corresponding to the input. The user interface 1161 may include the fingerprint sensor 1162, the input sensor 1163, and a digitizer 1164.

The fingerprint sensor 1162 may sense a fingerprint for biometric recognition of the user and may also measure one or more biological signals such as blood pressure, moisture, or body mass .

The input sensor 1163 may sense user interactions including touch, tap, gesture, motion, spoken command, and eye movement. The input sensor 1163 may include optical sensors for image capture, eye tracking, or motion and gesture detection. Optical sensors may be infrared or semiconductor photodetectors. The input sensor 1163 may include audio and acoustic sensors, which may be MEMS microphones for voice recognition or sound-based interaction. The audio and acoustic sensors can be installed as part of the user interface 1161 or embedded in the display panel 1141.

The digitizer 1164 may generate a data value corresponding to coordinate information of input by a pen or a mouse to control movement of an onscreen cursor. The digitizer 1164 may generate the amount of change in electromagnetic due to the input as the data value. The digitizer may detect an input by a passive pen or transmit and receive data with an active pen or a remote.

At least one of the fingerprint sensor 1162, the input sensor 1163, or the digitizer 1164 may be implemented as a sensor layer formed on the top layer of the display panel 1141 through a continuous process with a process of forming elements (for example, the light emitting element, the transistor, and the like) included in the display panel 1141.

In addition, the user interface 1161 may further include, for example, a gesture sensor, a gyro sensor that senses rotational movements, an acceleration sensor to track translational movement, a grip sensor, a pressure sensor, a proximity sensor, a color sensor, an infrared (IR) emitter and camera sensor for tracking gaze direction and eye movements, a temperature sensor, or a light sensor. For example, the gyro sensor, acceleration sensor, and infrared emitter and camera may be particularly suitable for AR/VR headset functions.

The touch screen 1142 may include touch sensors embedded in semiconductor layers of the display panel 1141 to sense pressure applied to the top layer (screen) of the display panel 1141. The touch sensors can be a capacitive or a resistive type. The touch screen 1142 may serve as the primary interface for the user to select and navigate applications, control, and interact with the electronic device 1000.

The display panel 1141 (or display) may include a liquid crystal display panel, an organic light emitting display panel, or an inorganic light emitting display panel, and the type of the display panel 1141 is not particularly limited. The display panel 1141 may be of a rigid type or a flexible type that can be rolled or folded. The display module 1140 may further include a supporter, bracket, heat dissipation member, and the like that support the display panel 1141. The display panel 1141 may include the display device 10 shown in FIG. 1.

The power source module 1150 may supply power to the components of the electronic device 1000. The power source module 1150 may include a battery that charges the power source voltage. The battery may include a non-rechargeable primary battery or a rechargeable secondary battery or fuel cell. The power source module 1150 may include a power management integrated circuit (PMIC). The PMIC may supply optimized power source to each of the components described herein including the display module 1140..

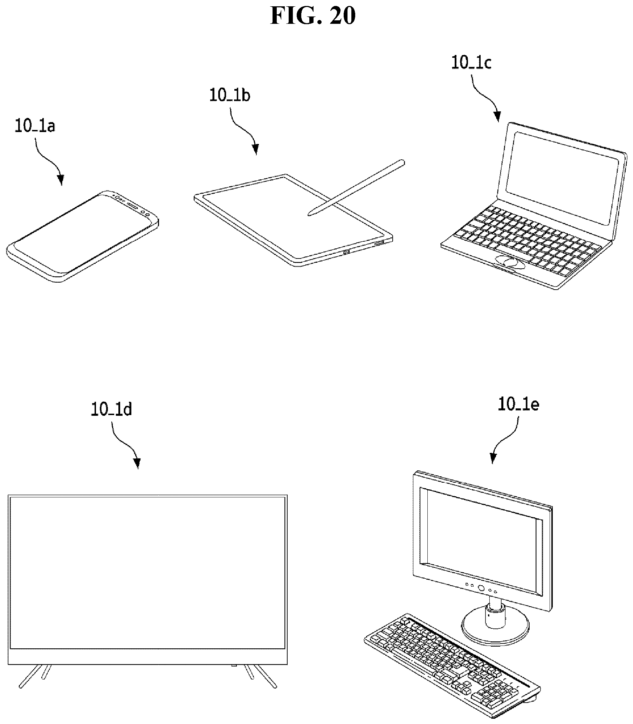

FIG. 20, FIG. 21, and FIG. 22 are schematic diagrams of electronic devices according to various embodiments. FIGS. 20 to 22 illustrate examples of various electronic devices to which the display device according to embodiments may be applied.

FIG. 20 illustrates a smartphone 10_1a, a tablet PC 10_1b, a laptop 10_1c, a TV 10_1d, and a desk monitor 10_1e as examples of electronic devices.

In addition to the display module 11, the smartphone 10_1a may include an input module such as a touch sensor and a communication module. The smartphone 10_1a may process information received through the communication module or other input modules and display the information through the display module of the display device.

In the case of tablet PCs 10_1b, laptops 10_1 c, TVs 10_1d, and desk monitors 10_1e, they also include display modules and input modules similar to smartphones 10_1, and may additionally include communication modules in some cases.

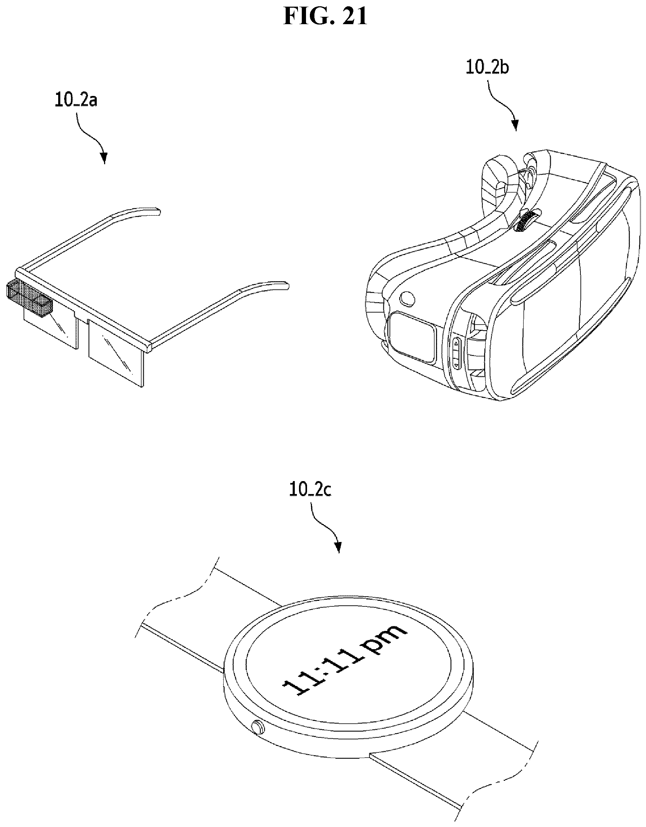

Fig. 21 shows an example of an electronic device including a display module being applied to a wearable electronic device. The wearable electronic device may be a smart glasses 10_2a, a head-mounted display 10_2b, a smart watch 10_2c, etc.

The smart glasses 10_2a and the head-mounted display 10_2b may each include a display module emitting light for forming an image and a reflector that reflects the emitted light and provides the emitted light to the user's eyes for perceiving the image. The smart glasses 10_2a and the head-mounted display 10_2b may each provide a virtual reality or augmented reality screen to the user.

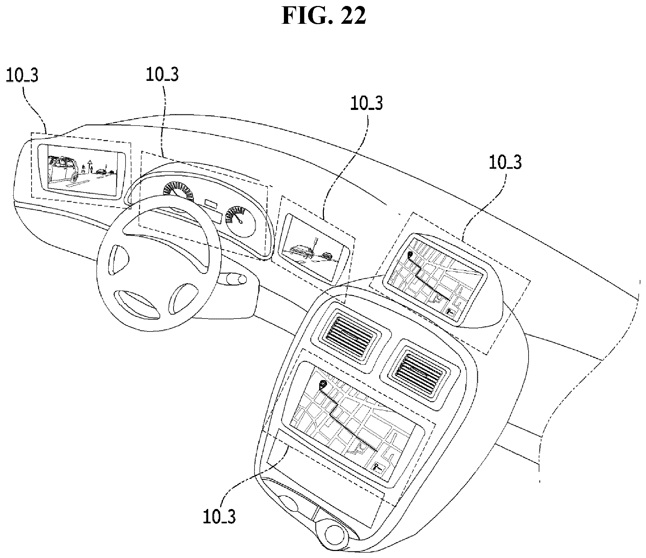

The smart watch 10_2c may include a biometric sensor as an input device, and may provide biometric information recognized by the biometric sensor to the user through the display module. Fig. 22 illustrates a case where an electronic device including a display module is deployed in a vehicle. For example, the electronic device 10_3 may be attached to a dashboard or a center fascia, for example, of a vehicle, or may be attached to a CID (Center Information Display) disposed on a dashboard of a vehicle, or a display for replacing a side mirror.

It will be able to be understood by one of ordinary skill in the art to which the present disclosure belongs that the present disclosure may be implemented in other specific forms without changing the essential features of the present disclosure. Therefore, it is to be understood that exemplary embodiments described herein are illustrative rather than being restrictive in all aspects. It is to be understood that the scope of the present disclosure are defined by the claims rather than the detailed description described herein and all modifications and alterations derived from the claims and their equivalents fall within the scope of the present disclosure.

## Claims

1. A display device (10) comprising:
a substrate (SSUB);
a plurality of first electrodes (AND) disposed on the substrate (SSUB);
a pixel defining layer (PDL) disposed on the plurality of first electrodes (AND) and having a trench (TRC);
a light emitting stack (IL) disposed on the plurality of first electrodes (AND) and the pixel defining layer (PDL); and
a dummy electrode (DM) disposed between the substrate (SSUB) and the trench (TRC), and between the plurality of first electrodes (AND),
the display device (10) is configured to apply a voltage to the dummy electrode (DM) and a voltage to the plurality of first electrodes (AND) which are different from each other.

2. The display device (10) of claim 1, wherein the dummy electrode (DM) is connected to one of a ground (GND), a driving voltage line (VSL) supplying a first driving voltage (VSS), or another driving voltage line (VIL) supplying an initialization voltage (VINT), and/or
the display device (10) is further configured to apply the voltage to the dummy electrode (DM) which is smaller than the voltage applied to the plurality of first electrodes (ANT).

3. The display device (10) of one of the preceding claims 1 and 2, wherein the dummy electrode (DM) overlaps the trench (TRC).

4. The display device (10) of one of the preceding claims 1 to 3, wherein the trench (TRC) defines a cavity, and a residual layer (RINS) is disposed on a bottom surface (FS) of the trench (TRC) below the cavity.

5. The display device (10) of one of the preceding claims 1 to 4, further comprising an insulating layer (INS11) disposed between the dummy electrode (DM) and the trench (TRC), and/or wherein a bottom surface (FS) of the trench (TRC) is disposed above, and spaced apart from, a top surface (TS) of the dummy electrode (DM).

6. The display device (10) of one of the preceding claims 1 to 3, wherein the dummy electrode (DM) and the trench (TRC) are connected to each other, and
a top surface (TS) of the dummy electrode (DM) defines a bottom surface (BS) of the trench (TRC).

7. The display device (10) of one of the preceding claims 1 to 6, wherein the dummy electrode (DM) is disposed along the trench (TRC) in a plan view, and/or wherein the pixel defining layer (PDL) has a plurality of trenches (TRC) surrounding different emission areas (EA1, EA2, EA3), and the dummy electrode (DM) overlaps a plurality of neighboring trenches (TRC).

8. The display device (10) of claim 7, wherein an edge of the dummy electrode (DM) overlaps the plurality of neighboring trenches (TRC).

9. The display device of claim 8, wherein a central portion of the dummy electrode (DM) overlaps the pixel defining layer (PDL) between the plurality of neighboring trenches (TRC).

10. The display device (10) of claim 1, wherein the dummy electrode (DM) does not overlap the trench (TRC), and
the dummy electrode (DM) overlaps the pixel defining layer (PDL),
and/or
the pixel defining layer (PDL) has a plurality of trenches (TRC) surrounding different emission areas (EA1, EA2, EA3), and
the dummy electrode (DM) overlaps a pixel defining layer (PDL) between a plurality of neighboring trenches (TRC).

11. The display device (10) of one of the preceding claims 1 to 10, wherein, in plan view, the dummy electrode (DM) surrounds an emission area (EA1, EA2, EA3) and defines the pixel defining layer (PDL), and/or wherein, in plan view, the dummy electrode (DM) has a through hole (PH1, PH2, PH3) surrounding the emission area (EA1, EA2, EA3).

12. The display device (10) of one of the preceding claims 1 to 11, wherein, between the substrate (SSUB) and the trench (TRC), the dummy electrode (DM) includes a plurality of dummy electrodes (DM1, DM2, DM3, DM4) disposed along a direction toward the trench (TRC) from the substrate (SSUB).

13. The display device (10) of one of the preceding claims 1 to 12, further comprising a reflective electrode (RL) connected to the first electrode,
wherein the dummy electrode (DM) is disposed on a same layer as the reflective electrode (RL), and
the dummy electrode (DM) is formed of a same material as the reflective electrode (RL).

14. An optical device comprising:
a display device (10) according to one of the preceding claims 1 to 13.

15. An electronical device comprising:
a display device (10) according to one of the preceding claims 1 to 13 including a display panel (100).
